# EUROPEAN PATENT SPECIFICATION

(11) **EP 1 612 247 B1**
(45) Date of publication and mention of the grant of the patent: **02.04.2008**
(21) Application number: 05013723.1
(22) Date of filing: 24.06.2005
(51) Int. Cl.: C09D 11/00, G03F 7/027, C09D 11/10

(54) **Ink composition for inkjet recording and method of producing lithographic printing plate using the same**
TINTE FÜR DEN TINTENSTRAHLDRUCK UND EINE HERSTELLUNGSMETHODE FÜR EINE LITHOGRAFISCHE DRUCKPLATTE MIT DIESER TINTE
COMPOSITION D' ENCRE POUR ENREGISTREMENT PAR JET D' ENCRE ET METHODE POUR LA PRODUCTION DE PLAQUE D' IMPRESSION LITHOGRAPHIQUE UTILISANT CET ENCRE.

(30) Priority: 28.06.2004 JP 2004189415
(43) Date of publication of application: 04.01.2006
(73) Proprietor: FUJIFILM Corporation, Minato-ku Tokyo (JP)
(72) Inventor: Kunita, Kazuto, Haibara-gun, Shizuoka (JP)
(74) Representative: HOFFMANN EITLE

(56) References cited:
- EP-A- 0 533 168
- EP-A- 0 641 648
- EP-A- 1 091 247
- EP-A- 1 223 467
- EP-A- 1 241 528
- EP-A- 1 249 731
- US-A- 6 014 931
- US-B1- 6 413 700
- PATENT ABSTRACTS OF JAPAN vol. 012, no. 343 (M-741), 14 September 1988 (1988-09-14) & JP 63 102936 A (CANON INC), 7 May 1988 (1988-05-07)
- PATENT ABSTRACTS OF JAPAN vol. 017, no. 631 (P-1648), 22 November 1993 (1993-11-22) & JP 05 204138 A (NIPPON PAINT CO LTD), 13 August 1993 (1993-08-13)

## Description

### Field of the Invention

The present invention relates to an ink composition for inkjet recording and a method of producing a lithographic printing plate using such an ink composition. More specifically, the invention relates to an ink composition for inkjet recording, which is highly sensitive to radiation exposure, can form images of high quality and has satisfactory storage stability, and the invention relates to a method of producing a lithographic printing plate that requires no development-processing and ensures a long press life and formation of high-quality images.

### Background Art of the Invention

As image-recording methods in which images are formed on recording materials, such as paper, according to image-data signals, there are electrophotographic methods, thermal transfer methods of sublimation or fusion type and inkjet methods. The electrophotographic methods require a process of forming electrostatic images on a photoconductor drum by electrification and light exposure, so they have a problem that such a process makes their systems complex and results in a rise of production cost. And the thermal transfer methods, though the apparatus used therein is inexpensive, have a drawback that ink ribbons used therein bring about a rise in running cost, and besides, they are discarded as rubbish. In the inkjet methods, on the other hand, not only the apparatus used is inexpensive but also efficient use of ink becomes possible and the running cost is inexpensive because ink is ejected on only the desired image areas and form images directly on recording materials. In addition, the inkjet methods are reduced in noises. Therefore, it can be said that the inkjet methods are outstanding image-recording methods.

As one of the inkjet methods, there is a recording method using inkjet recording ink that can be cured upon radiation exposure.

For instance, the inkjet method of ultraviolet cure type has received attention in recent years because it gives off a relatively weak odor, can ensure rapid drying properties and enables recording on recording materials free of ink absorption. JP-A-2003-192943 proposes the composition containing a coloring material and a polymerizing compound selected from the specific group of acrylate compounds with the intention of providing inkjet recording ink that can achieve high-sensitivity recording of images free of ink spread and highly adhesive to recording materials, and besides, that has less irritation to skin and less sensitization, namely high safety.

Inkjet recording ink capable of being cured upon exposure to radiation including ultraviolet light (radiation-curable inkjet recording ink) is required to offer sufficiently high sensitivity and high image quality. Achievement of high sensitivity to radiation results in high curability and brings many benefits including a reduction in power consumption, an increase in lifespan of a radiation generator by reducing a load thereon and prevention of low-molecular-weight materials resulting from insufficient curing. When the inkjet recording ink is used specifically as the image part of a lithographic printing plate, the increased sensitivity effects an increase in cured strength of the image part and ensures a long press life.

On the other hand, it is required for achieving high image quality that ink particles keep their original state (without being crushed) after they are ejected to a recording material and cause no deformation (neither spread nor absorption) on the recording material until they undergo fixation by curing with radiation.

However, related arts including the art disclosed in JP-A-2003-192943 fall short of offering inkjet recording radiation-curable ink sufficient to ensure high sensitivity and high image quality.

### Summary of the Invention

Therefore, An object of an illustrative, non-limiting embodiment of the invention is to provide an ink composition for inkjet recording which is highly sensitive to radiation exposure, can form high-quality images and has satisfactory storage stability, and further to provide a method of producing a lithographic printing plate that requires no development-processing, has high impression capacity and can form high-quality images.

The following are illustrative, non-limiting embodiments of the invention:
(1) An ink composition for inkjet recording, capable of being cured upon radiation exposure, which comprises: a coloring material; and a polymerizing compound having a structure represented by formula (I): 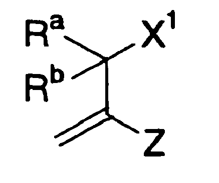 wherein R^{a} and R^{b} each independently represent a hydrogen atom, a halogen atom, a cyano group or an organic group; Z represents CN or COX²; X¹ represents a halogen atom or a group bonded to α-carbon via a hetero atom; X² represents a halogen atom or a group bonded to the carbonyl group via a hetero atom; and X¹ and X², R^{a} and R^{b}, X¹ and R^{a}, or X¹ and R^{b} may combine with each other to form a ring structure.
(2) A method of producing a lithographic printing plate, comprising: ejecting (or discharging) an ink composition for inkjet recording onto a hydrophilic substrate, the ink composition comprising a coloring material and a polymerizing compound; and irradiating the ink composition on the hydrophilic substrate to cure the ink composition, so as to form an image.
(3) The method of producing a lithographic printing plate as described in (2), wherein the polymerizing compound is a compound having a structure represented by formula (I): 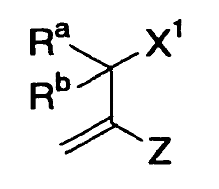
wherein R^{a} and R^{b} each independently represent a hydrogen atom, a halogen atom, a cyano group or an organic group; Z represents CN or COX²; X¹ represents a halogen atom or a group bonded to α-carbon via a hetero atom; X² represents a halogen atom or a group bonded to the carbonyl group via a hetero atom; and X¹ and X², R^{a} and R^{b}, X¹ and R^{a}, or X¹ and R^{b} may combine with each other to form a ring structure.

### Detailed Description of the Invention

As a result of our intensive studies, it has been found that the use of a compound having a structure represented by the foregoing formula (I) (hereinafter referred to as "an α-heteromethacrylic compound," too) as a polymerizing compound in an ink composition can provide improvements in ejectability, particle-shape retainability and curability of the ink composition. Many of the α-heteromethacrylic compounds have melting points near to room temperature and self-cohesive properties as to cause gradual crystallization, so they can jet out smoothly at ejection time, and after ejection they can have satisfactory particle-shape retaining properties (crush resistance, no spread on a recording material, no absorption into a recording material).

In addition, the α-heteromethacrylic compounds used in the invention have properties of being highly polymerizable and resistant to inhibition of polymerization by oxygen, compared with the acrylic compounds as disclosed in JP-A-2003-192943.

Therefore, high degrees of curing are attained when the present compounds are irradiated with ultraviolet light and electron beams, and the curability becomes remarkable especially in the ultraviolet curing performed in the atmosphere.

According to an exemplary embodiment of the present method for producing a lithographic printing plate, the present inkjet recording ink composition is used, so the cured strength of image part is heightened, and besides, the adhesion of the image part to a substrate becomes strong, compared with those currently in use. As a reason why such effects are produced, it is supposed that the self-cohesive force of the α-heteromethacrylic compound used comes into play after curing to enhance the cured strength and cause highly chemical interaction, such as chelation, between the α-heteromethacrylic compound molecules and atoms present at the substrate surface to result in enhancement of adhesion to the substrate.

Further, the α-heteromethacrylic compounds are less prone to being thermally polymerized in the absence of a polymerization initiator than acrylic compounds, so they are superior in storage stability.

Therefore, the invention can provide an inkjet recording ink composition that is highly sensitive to radiation exposure, can form images of high quality and has satisfactory storage stability, and a method of making a lithographic printing plate requiring no development-processing, having high impression capacity and ensuring high-quality image formation.

An exemplary embodiment will now be described below.

The present ink composition can be cured upon irradiation exposure, and contains a coloring material and a polymerizing compound having a specific structure. The term "radiation" as used in the invention has a broad meaning, and is intended to include α-rays, γ-rays, X-rays, ultraviolet rays, visible rays and electron beams. However, the invention aims at providing ink compositions suitable for curing upon irradiation with ultraviolet rays and electron beams, especially ultraviolet rays.

### <<Polymerizing Compounds>>

The distinctive compounds in the invention are compounds which each have a structure represented by formula (I) and contain at least one polymerizing group. The structure represented by formula (I) may form a substituent with a valence of 1, 2 or more, or it may form a compound on its own by allowing all of R^{a}, R^{b}, X¹ and X² in formula (I) to represent terminal groups. When the structure represented by formula (I) forms a substituent with a valence of 1, 2 or more, at least one of the groups R^{a}, R^{b}, X¹ and X² in formula (I) has at least one bonding hand. Further, either X¹ or X² may be a linkage group having n linkable sites (n: an integer of 2 or more); wherein the linkage group may be linked with n substituents represented by formula (I) at its terminals (to form a polymer).

Alternatively, the structure represented by formula (I) may be attached to a polymer chain via at least one of X¹ and X². In other words, the structure may take the form of being present in some side chains of a polymer chain. Examples of such a polymer chain include linear organic high polymers. More specifically, polyurethane, novolak, vinyl polymers including polyvinyl alcohol, poly(hydroxystyrene), polystyrene, poly(meth)acrylate, poly(meth)acrylamide and polyacetal are included in those linear organic high polymers. These polymers may be homopolymers or copolymers.

In formula (I), X¹ represents a group bonded to the α-carbon via a hetero atom, or a halogen atom, and X² represents a group bonded to the carbonyl group via a hetero atom, or a halogen atom. Those groups may be terminal groups, or they may be linkage groups and linked with other substituents (including the structure of formula (I) and polymer chains as mentioned above). The hetero atom is preferably a nonmetal atom, with examples including an oxygen atom, a sulfur atom, a nitrogen atom and a phosphorus atom. Examples of a halogen atom include a chlorine atom, a bromine atom, an iodine atom and a fluorine atom. Examples of a group suitable as X¹ representing a group bonded to α-carbon via a hetero atom include a hydroxyl group, a substituted oxy group, a mercapto group, a substituted thio group, an amino group, a substituted amino group, a sulfo group, a sulfonato group, a substituted sulfinyl group, a substituted sulfonyl group, a phosphono group, a substituted phosophono group, a phosphonato group, a substituted phosphonato group, a nitro group and a heterocyclic group (linked via the hetero atom). Examples of a group suitable as X² representing a group bonded to carbonyl group via a hetero atom include a hydroxyl group, a substituted-oxy group, a mercapto group, a substituted thio group, an amino group, a substituted amino group and a heterocyclic group.

Alternatively, X¹ and X² may combine with each other to form a ring structure.

R^{a} and R^{b} independently represent a hydrogen atom, a halogen atom, a cyano group or an organic group. Examples of such an organic group include a hydrocarbon group which may have a substituent and may contain an unsaturated bond, a substituted oxy group, a substituted thio group, a substituted amino group, a substituted carbonyl group and a carboxylato group. Alternatively, R^{a} and R^{b} may combine with each other to from a ring structure.

Examples of each of the groups or substituents recited above with respect to X¹, X², R^{a} and R^{b} in formula (I) are described below.

Examples of the hydrocarbon group that may have a substituent and may contain an unsaturated bond include an alkyl group, a substituted alkyl group, an aryl group, a substituted aryl group, an alkenyl group, a substituted alkenyl group, an alkynyl group and a substituted alkynyl group.

The alkyl group is a linear, branched or cyclic alkyl group containing 1 to 20 carbon atoms. Examples of such an alkyl group include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, a s-butyl group, a t-butyl group, an isopentyl group, a neopentyl group, a 1-methylbutyl group, an isohexyl group, a 2-ethylhexyl group, 2-methylhexyl group, a cyclohexyl group, a cyclopentyl group and a 2-norbornyl group. Of these groups, the 1-12C linear alkyl groups, the 3-12C branched alkyl groups and the 5-10C cycloalkyl groups are preferred over the others.

The substituted alkyl group is made up by combination of an alkylene group with a substituent, and the substituent used herein is a monovalent nonmetallic radical other than hydrogen. Suitable examples of such a radical include halogen radicals (-F, -Br, -Cl, -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, N'-aryl-N-arylureido group, an N',N'-diaryl-N-alkylureido group, an N',N'-diaryl-N-arylureido group, N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group and a conjugate base group thereof (hereinafter referred to as "a carboxylato group"), an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and a conjugate base group thereof (hereinafter referred to as "a sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugate base group thereof, an N-alkylsulfonylsulfamoyl group (-SO₂NHSO₂(alkyl)) and a conjugate base group thereof, an N-arylsulfonylsulfamoyl group (-SO₂NHSO₂(aryl)) and a conjugate base group thereof, an N-alkylsulfonylcarbamoyl group (-CONHSO₂(alkyl)) and a conjugate base group thereof, an N-arylsulfonylcarbamoyl group (-CONHSO₂(aryl)) and a conjugate base group thereof, an alkoxysilyl group (-Si(O-alkyl)₃), an aryloxysilyl group (-Si(O-aryl)₃), a hydroxysilyl group (-Si(OH)₃) and a conjugate base group thereof, a phosphono group (-PO₃H₂) and a conjugate base group thereof (hereinafter referred to as "a phosphonato group"), a dialkylphosphono group, -PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugate base group thereof (hereinafter referred to as " an alkylphosphonato group"), a monoarylphosphono group (-PO₃H(aryl)) and a conjugate base group thereof (hereinafter referred to as "an arylphosphonato group), a dialkylphosphonoxy group (-OPO₃(alkyl)₂), a diarylphosphonoxy group (-OPO₃(aryl)₂), an alkylarylphosphonoxy group (-OPO₃(alkyl)(aryl)), a monoalkylphosphonoxy group (-OPO₃H(alkyl)) and a conjugate base group thereof (hereinafter referred to as "an alkylphosphonatoxy group), a monoarylphosphonatoxy group (-OPO₃H(aryl)) and a conjugate base group thereof (hereinafter referred to as "an arylphosphonatoxy group), a cyano group, a nitro group, an aryl group, an alkenyl group and an alkynyl group.

Examples of the alkyl moieties in those substituents include the alkyl groups as recited above. And examples of the aryl moieties in those substituents include a phenyl group, a biphenyl group, a naphthyl group, a tolyl group, a xylyl group, a mesityl group, a cumenyl group, a fluorophenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a phenyl group, a nitrophenyl group, a cyanophenyl group, a sulfophenyl group, a sulfonatophenyl group, a phosphonophenyl group and a phosphonatophenyl group. Examples of an alkenyl group as the foregoing substituent include a vinyl group, a 1-propenyl group, a 1-butenyl grup, a cinnamyl group and a 2-chloro-1-ethenyl group, and those of an alkynyl group as the foregoing substituent include an ethynyl group, a 1-propynyl group, a 1-butynyl group, a trimethylsilylethynyl group and a phenylethynyl group.

The acyl moieties in the substituents recited above are represented by R⁴CO-, and examples of R⁴ herein include a hydrogen atom and the alkyl, aryl, alkenyl and alkynyl groups as recited above. On the other hand, the alkylene moiety in the substituted alkyl group may be a divalent organic group derived from a 1-20C alkyl group by removal of any one hydrogen atom, which is preferably a 1-12C linear, 3-12C branched or 5-10C cyclic alkylene group. Suitable examples of the substituted alkyl group include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a mopholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, a methoxycarbonylmethyl group, a methoxycarbonylbutyl group, an ethoxycarbonylmethyl group, a butoxycarbonylmethyl group, an allyloxycarbonylmethyl group, a benzyloxycarbonylmethyl group, a methoxycarbonylphenylmethyl group, a trichloromethylcarbonylmethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfopropyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a triphosphonohexyl group, a tolylphosphonatohexyl group, a phosphonoxypropyl group, a phosphonatoxybutyl group, a benzyl group, a phenethyl group, an α-methylbenzyl group, a 1-methyl-1-phenylethyl group, a p-methylbenzyl group, a cinnamyl group, an allyl group, a 2-propenylmethyl group, a 2-butenyl group, a 2-methylallyl group, a 2-methylpropenylmethyl group, a 2-propynyl group, a 2-butynyl group, a 3-butynyl group and the groups illustrated below:

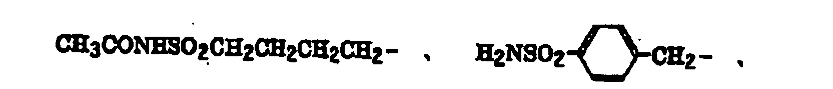

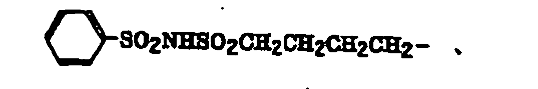

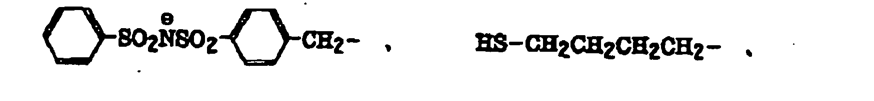

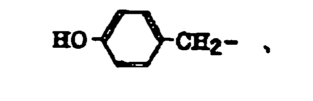

The aryl group can be a group derived from a benzene ring, a ring formed by fusing two or three benzene rings together, or a ring formed by fusing a 5-membered unsaturated ring with at least one benzene ring, with examples including a phenyl group, a naphthyl group, an anthryl group, a phenanthryl group, an indenyl group, an acenaphthenyl group and a fluorenyl group. Of these aryl groups, a phenyl group and a naphthyl group are preferred over the others.

The substituted aryl group is an aryl group to which a substituent is attached, specifically a group having a monovalent nonmetallic radical, other than hydrogen, as a substituent on a carbon atom forming a ring of the aryl group as recited above. Suitable examples of such a substituent include the alkyl and substituted alkyl groups and the substituents included in the substituted alkyl groups as recited above. And suitable examples of such a substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, a phenylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and 3-butynylphenyl group.

The alkenyl group can be any of the alkenyl groups as recited above. The substituted alkenyl group is an alkenyl group to which a substituent is attached by being substituted for a hydrogen atom of the alkenyl group. The substituent usable herein includes the substituents in the substituted alkyl groups as recited above, while the alkenyl group usable herein includes the alkenyl groups as recited above. Suitable examples of such a substituted alkenyl group include the groups illustrated below:

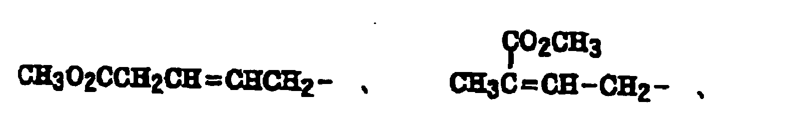

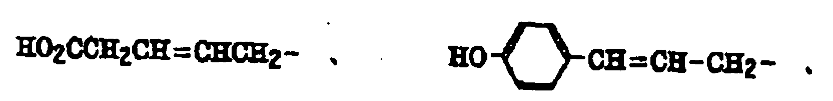

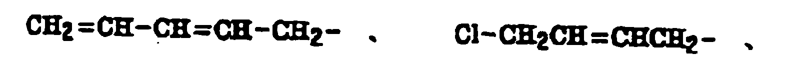

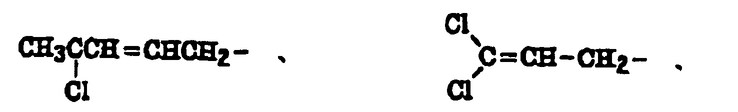

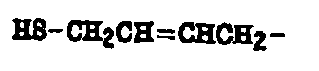

The alkynyl group can be any of the alkynyl groups as recited above. The substituted alkynyl group is an alkynyl group to which a substituent is attached by being substituted for a hydrogen atom of the alkynyl group. The substituent usable herein includes the substituents in the substituted alkyl groups as recited above, while the alkynyl group usable herein includes the alkynyl groups as recited above.

The term "heterocyclic group" is intended to include a monovalent group derived from a hetero ring by removal of one hydrogen atom and a monovalent group formed by further removing one hydrogen atom from the hetero ring and attaching thereto a substituent as included in those of the substituted alkyl groups recited above (a substituted heterocyclic group). Suitable examples of such a hetero ring are illustrated below:

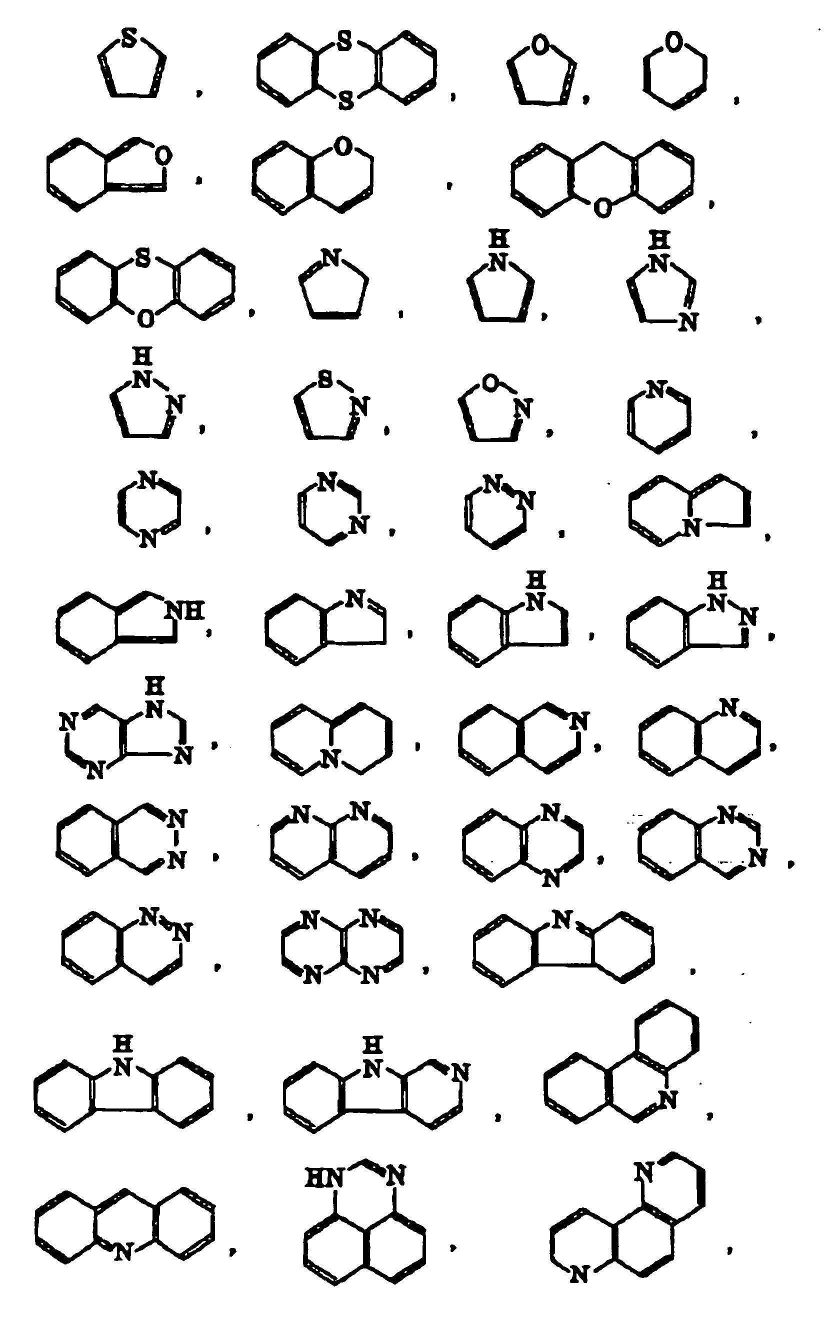

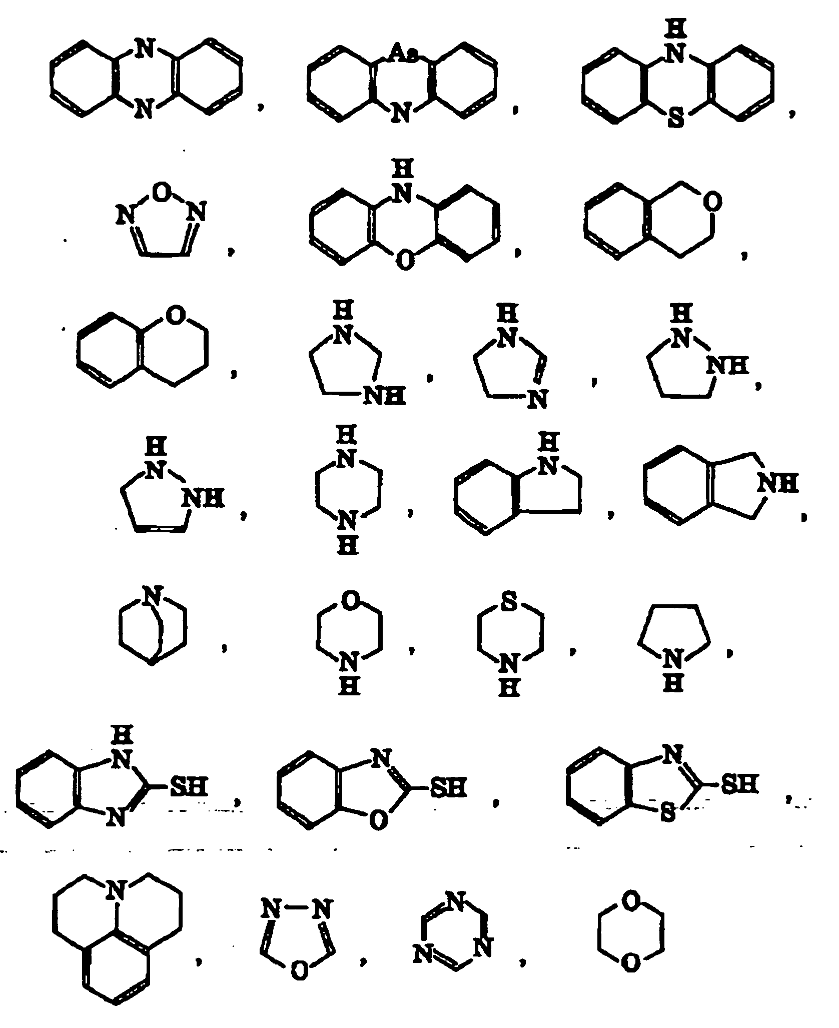

The substituted oxy group is represented by R⁵O-, and as the R⁵ can be used a monovalent nonmetallic radical other than hydrogen. Suitable examples of such a substituted oxy group include an alkoxy group, an aryloxy group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, a phosphonoxy group and a phosphonatoxy group. Examples of the alkyl or aryl moieties in those groups include the alkyl and substituted alkyl groups as recited above or the aryl and substituted aryl groups as recited above, respectively. The acyl moiety in the acyloxy group is represented by R⁶CO-, and examples of the R⁶ include the alkyl, substituted alkyl, aryl and substituted aryl groups as recited above. Of those substituents, alkoxy, aryloxy, acyloxy and arylsulfoxy groups are preferred over the others. Suitable examples of the substituted oxy group include a methoxy group, an ethoxy group, a propoxy group, an isopropyloxy group, a butyloxy group, a pentyloxy group, a hexyloxy group, a dodecyloxy group, a benzyloxy group, an allyloxy group, a phenethyloxy group, a carboxyethyloxy group, a methoxycarbonylethyloxy group, an ethoxycarbonylethyloxy group, a methoxyethoxy group, a phenoxyethoxy group, a methoxyethoxyethoxy group, an ethoxyethoxyethoxy group, a morpholinoethoxy group, a morpholinopropyloxy group, an allyloxyethoxyethoxy group, a phenoxy group, a tolyloxy group, a xylyloxy group, a mesityloxy group, a cumenyloxy group, a methoxyphenyloxy group, an ethoxyphenyloxy group, a chlorophenyloxy group, a bromophenyloxy group, an acetyloxy group, a benzoyloxy group, a naphthyloxy group, a phenylsulfonyloxy group, a phosphonoxy group and a phosphonatoxy group.

The substituted thio group is represented by R⁷S-, and as the R⁷ can be used a monovalent nonmetallic radical other than hydrogen. Suitable examples of such a substituted thio group include an alkylthio group, an arylthio group, an alkyldithio group, an aryldithio group and an acylthio group. The alkyl or aryl moieties in those groups include the alkyl and substituted alkyl groups as recited above or the aryl and substituted aryl groups as recited above, respectively. The acyl moiety in the acylthio group is represented by R⁶CO-, and herein the R⁶ has the same examples as recited above. Of these substituted thio groups, alkylthio and arylthio groups are preferred over the others. Suitable examples of such substituted thio groups include a methylthio group, an ethylthio group, a phenylthio group, an ethoxyethylthio group, a carboxyethylthio group and a methoxycarbonylthio group.

The substituted amino group is represented by R⁸NH- or (R⁹)(R¹⁰)N-, and as R⁸, R⁹ and R¹⁰ each can be used a monovalent nonmetallic radical other than hydrogen. Suitable examples of such substituted amino groups include an N-alkylamino group, an N,N-dialkylamino group, an N-arylamino group, an N,N-diarylamino group, an N-alkyl-N-arylamino group, an acylamino group, an N-alkylacylamino group, an N-arylacylamino group, an ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group and an N-aryl-N-aryloxycarbonylamino group. The alkyl or aryl moieties in these groups include the alkyl and substituted alkyl groups as recited above or the aryl and substituted aryl groups as recited above, respectively. And the acyl moieties in those acylamino, N-alkylacylamino and N-arylacylamino groups are represented by R⁶CO-, wherein R⁶ is the same one as mentioned above. Of those substituted amino groups, N-alkylamino, N,N-dialkylamino, N-arylamino and acylamino groups are preferred over the others. Suitable examples of such substituted amino groups include a methylamino group, an ethylamino group, a diethylamino group, a morpholino group, a piperidino group, a pyrrolidino group, a phenylamino group, a benzoylamino group and an acetylamino group.

The substituted carbonyl group is represented by R¹¹-CO-, and as the R¹¹ can be used a monovalent nonmetallic radical. Suitable examples of such a substituted carbonyl group include a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group and an N-alkyl-N-arylcarbamoyl group. The alkyl or aryl moieties in these groups include the alkyl and substituted alkyl groups as recited above or the aryl and substituted aryl groups as recited above, respectively. Of those substituted carbonyl groups, formyl, acyl, carboxyl, alkoxycarbonyl, aryloxycarbonyl, carbamoyl, N-alkylcarbamoyl, N,N-dialkylcarbamoyl and N-arylcarbamoyl groups are preferred over the others. Of these groups, formyl, acyl, alkoxycarbonyl and aryloxycarbonyl groups are preferred by far. More specifically, a formyl group, an acetyl group, a benzoyl group, a carboxyl group, a methoxycarbonyl group, an allyloxycarbonyl group, an N-methylcarbamoyl group, an N-phenylcarbamoyl group, an N,N-diethylcarbamoyl group and a morpholinocarbonyl group are suitable as the substituted carbonyl groups mentioned above.

The substituted sulfinyl group is represented by R¹²-SO-, and as the R¹² can be used a monovalent nonmetallic radical. Suitable examples of such a substituted sulfinyl group include an alkylsulfinyl group, an arylsulfinyl group, a sulfinamoyl group, an N-alkylsulfinamoyl group, an N,N-dialkylsulfinamoyl group, an N-arylsulfinamoyl group, an N,N-diarylsulfinamoyl group and an N-alkyl-N-arylsulfinamoyl group. The alkyl or aryl moieties in these groups include the alkyl and substituted alkyl groups as recited above or the aryl and substituted aryl groups as recited above, respectively. Of those groups, alkylsulfinyl and arylsulfinyl groups are preferred over the others. Examples of such substituted sulfinyl groups include a hexylsulfinyl group, a benzylsulfinyl group and a tolylsulfinyl group.

The substituted sulfonyl group is represented by R¹³-SO₂-, and as the R¹³ can be used a monovalent nonmetallic radical. Preferable examples of such a substituted sulfonyl group include an alkylsulfonyl group and an arylsulfonyl group. The alkyl or aryl moiety of these groups includes the alkyl and substituted alkyl groups as recited above or the aryl and substituted aryl groups as recited above, respectively. Examples of such a substituted sulfonyl group include a butylsulfonyl group and a chlorophenylsulfonyl group.

The sulfonato group (-SO₃⁻) is, as mentioned above, the anion moiety of a conjugate base of sulfo group (-SO₃H). In general the sulfonato group is preferably used together with a counter cation. Examples of such a counter cation include generally known cations, such as various oniums (e.g., ammoniums, sulfoniums, phosphoniums, iodoniums and aziniums) and metal ions (e.g., Na⁺, K⁺, Ca²⁺, Zn²⁺).

The carboxylato group (-CO₂⁻) is, as mentioned above, the anion moiety of a conjugate base of carboxyl group (-CO₂H). In general the carboxylato group is preferably used together with a counter cation. Examples of such a counter cation include generally known cations, such as various oniums (e.g., ammoniums, sulfoniums, phosphoniums, iodoniums and aziniums) and metal ions (e.g., Na⁺, K⁺, Ca²⁺, Zn²⁺).

The term "substituted phosphono group" refers to a group formed by subtituting one or two organic oxo groups for one or two hydroxyl groups on phosphono group, and suitable examples of such a group include the dialkylphosphono, diarylphosphono, alkylarylphosphono, monoalkylphosphono and monoarylphosphono groups as mentioned above. Of these groups, the dialkylphosphono and diarylphosphono groups are preferred over the others. Examples of such groups include a diethylphosphono group, a dibutylphosphono group and a diphenylphosphono group.

The phosphonato group (-PO₃²⁻ or -PO₃H⁻) refers, as mentioned above, to the anion moiety of a conjugate base derived from first- or second-stage acidic dissociation of phosphono group (-PO₃H₂). In general the phosphonato group is preferably used together with a counter cation. Examples of such a counter cation include generally known cations, such as various oniums (e.g., ammoniums, sulfoniums, phosphoniums, iodoniums and aziniums) and metal ions (e.g., Na⁺, K⁺, Ca²⁺, Zn²⁺).

The substituted phosphonato group is the conjugate base anion moiety of a group formed by substituting an organic oxo group for one hydroxyl group in any of the substituted phosphono groups as recited above. Examples thereof include conjugate bases of the monoalkylphosphono (-PO₃H(alkyl)) and monoarylphosphono (-PO₃H(aryl)) groups as mentioned above. In general these groups are preferably used together with counter cations. Examples of such counter cations include generally known cations, such as various oniums (e.g., ammoniums, sulfoniums, phosphoniums, iodoniums and aziniums) and metal ions (e.g., Na⁺, K⁺, Ca²⁺, Zn²⁺).

Examples of a ring structure formed by combining X¹ with X², R^{a} with R^{b}, or X¹ with R^{a} or R^{b} are described below. The ring formed by combining X¹ with X², R^{a} with R^{b}, or X¹ with R^{a} or R^{b} can be a 5-, 6-, 7- or 8-membered aliphatic ring, preferably a 5- or 6-membered aliphatic ring. Such an aliphatic ring may have a substituent on a carbon atom as a constituent of the ring (examples of such a substituent include the substituents of the substituted alkyl groups as recited above), and some of the ring-constituting carbons may be replaced by a hetero atom or hetero atoms (e.g., oxygen, sulfur or/and nitrogen atoms). Further, part of such an aliphatic ring as recited above may form part of an aromatic ring.

Examples of compounds having the structure represented by formula (I) in the invention are illustrated below, but these examples should not be construed as limiting the scope of the invention in any way.

### i) Monofuctional Compounds

### (Group A)

**Table-1**

| | | |
|---|---|---|
| 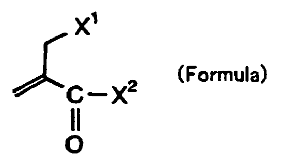 | | |

| No. | X¹ | X² |
|---|---|---|
| A-1 | OH | OCH₃ |
| A-2 | OH | O(n)C₄H₉ |
| A-3 | OH | O(n)C₁₂H₂₅ |
| A-4 | OH | 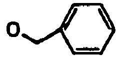 |
| A-5 | OH | 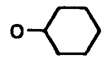 |
| A-6 | OH | 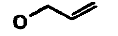 |
| A-7 | OH | 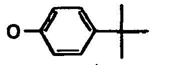 |
| A-8 | OCH₃ | OC₂H₅ |
| A-9 | 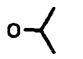 | O(n)C₄H₉ |
| A-10 | O(n)C₈H₁₇ | OCH₃ |
| A-11 | 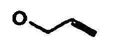 | 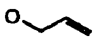 |
| A-12 | 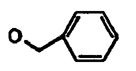 | OCH₃ |
| A-13 | 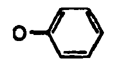 | OCH₃ |
| A-14 | 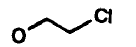 | OCH₃ |
| A-15 | 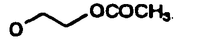 | OC₂H₅ |
| A-16 | 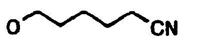 | OC₂H₆ |
| A-17 | OCOCH₃ | OCH₃ |
| A-18 | OCO(n)C₆H₁₃ | OCH₃ |
| A-19 | 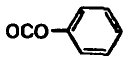 | OCH₃ |
| A-20 | OSO₂CH₃ | OCH₃ |
| A-21 | OSO₂(n)C₄H₉ | OCH₃ |
| A-22 | 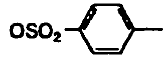 | OCH₃ |
| A-23 | OSO₂CF₃ | OC₂H₅ |
| A-24 | SCH₃ | OC₂H₅ |
| A-25 | S(n)C₄H₉ | OC₂H₅ |
| A-26 | 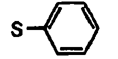 | OC₂H₆ |
| A-27 | 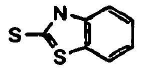 | OCH₃ |
| A-28 | 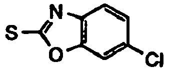 | OCH₃ |
| A-29 | F | O(n)C₁₂H₂₅ |
| A-30 | F | 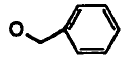 |
| A-31 | Cl | OCH₃ |
| A-32 | Cl | 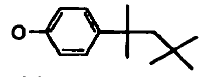 |
| A-33 | Br | O(n)C₄H₉ |
| A-34 | Br | 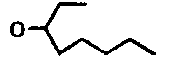 |
| A-35 | I | O(n)C₄H₉ |
| A-36 | I | 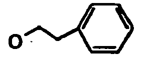 |
| A-37 | 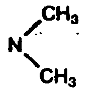 | OC₂H₅ |
| A-38 | 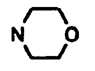 | OC₂H₅ |
| A-39 | 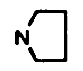 | OC₂H₅ |
| A-40 | 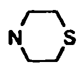 | OC₂H₆ |
| A-41 | 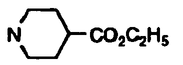 | OC₂H₆ |
| A-42 | 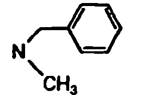 | OC₂H₅ |
| A-43 | 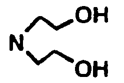 | OC₂H₅ |
| A-44 | 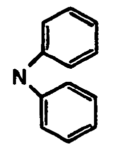 | OC₂H₅ |
| A-45 | 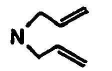 | OC₂H₆ |
| A-46 | NHCOCH₃ | OCH₃ |
| A-47 | NHCO(n)C₄H₉ | O(n)C₄H₉ |
| A-48 | 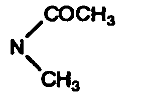 | OCH₃ |
| A-49 | NHSO₂CH₃ | O(n)C₄H₉ |
| A-50 | 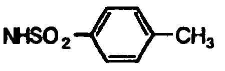 | O(n)C₄H₉ |
| A-51 | OCOCH₃ | 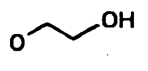 |
| A-52 | OCOCH₃ | 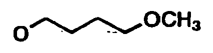 |
| A-53 | OCOCH₃ | 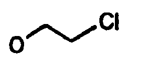 |
| A-54 | OCOCH₃ | 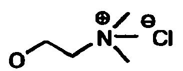 |
| A-55 | OCOCH₃ | 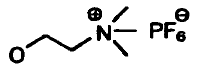 |
| A-56 | OCOC₂H₅ | 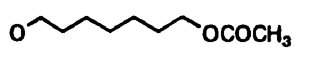 |
| A-57 | OOOC₂H₅ | 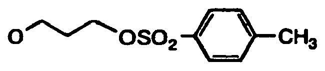 |
| A-58 | OCOC₂H₅ | 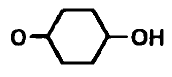 |
| A-60 | 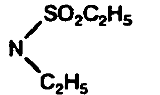 | OCH₃ |
| A-70 | OOOCH₃ | 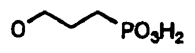 |
| A-71 | OCOCH₃ | 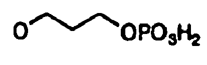 |
| A-72 | OCOCH₃ | 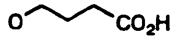 |
| A-73 | 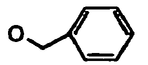 | OH |
| A-74 | 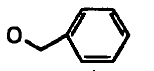 | O^{⊖}Na^{⊕} |
| A-75 | 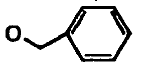 | 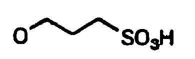 |
| A-76 | 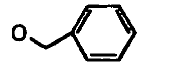 | 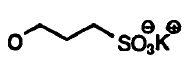 |
| A-77 | 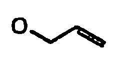 | 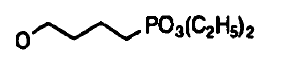 |
| A-78 | 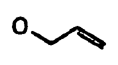 | 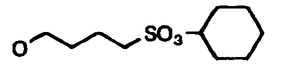 |
| A-79 | OH | OC₂H₅ |
| A-80 | 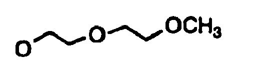 | OCH₃ |
| A-81 | 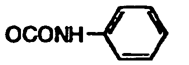 | OCH₃ |
| A-82 | 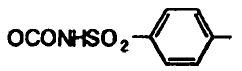 | OCH₃ |
| A-83 | 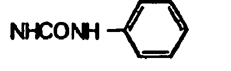 | OCH₃ |
| A-84 | NHCO₂(n)C₆H₁₃ | OCH₃ |
| A-85 | OCSNH(n)C₄H₉ | OCH₃ |
| A-86 | OCO(n)C₁₈H₃₇ | OCH₃ |

### (Group B)

**Table 2**

| | |
|---|---|
| B-1 | 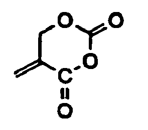 |
| B-2 | 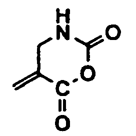 |
| B-3 | 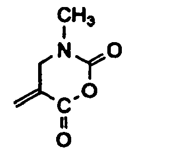 |
| B-4 | 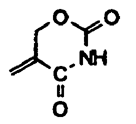 |
| B-5 | 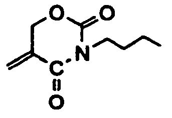 |
| B-6 | 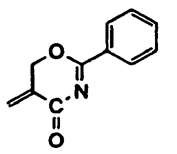 |
| B-7 | 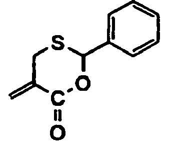 |
| B-8 | 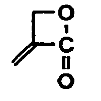 |
| B-9 | 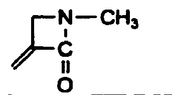 |

### ii) Difunctional Compounds

### (Group C)

**Table 3**

| | | |
|---|---|---|
| 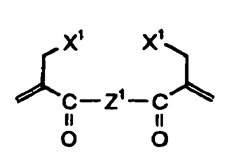 | | |

| No. | X¹ | Z¹ |
|---|---|---|
| C-1 | OH | 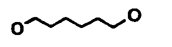 |
| C-2 | OH | 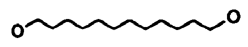 |
| C-3 | OCOCH₃ | 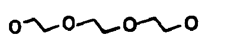 |
| C-4 | OCOCH₃ | 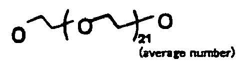 |
| C-5 | OH | 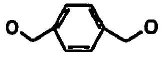 |
| C-6 | OH | 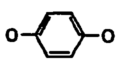 |
| C-7 | OH | 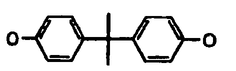 |
| C-8 | OH | 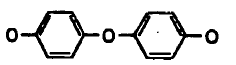 |
| C-9 | OCH₃ | 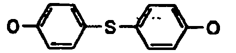 |
| C-10 | 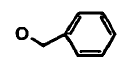 | 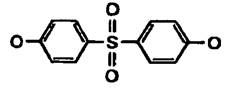 |
| C-11 | OCOC₂H₅ | 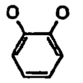 |
| C-12 | OCOC₂H₅ | 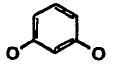 |
| C-13 | OH | 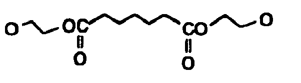 |
| C-14 | OCOCH₃ | 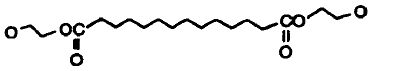 |
| C-15 | 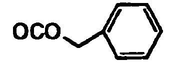 | 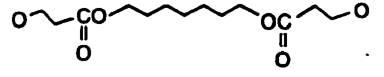 |
| C-16 | OH | 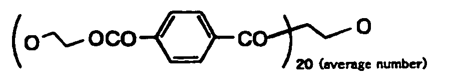 |
| C-17 | OH | 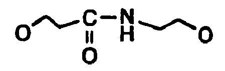 |
| C-18 | OH | 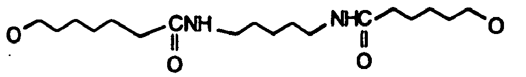 |
| C-19 | OCOCH₃ | 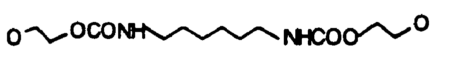 |
| C-20 | OCOCH₃ | 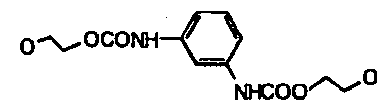 |
| C-21 | OCO(n)Pr | 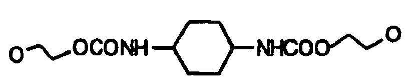 |
| C-22 | OCO(n)Pr | 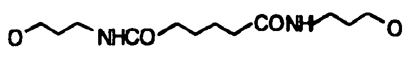 |
| C-23 | 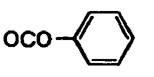 | 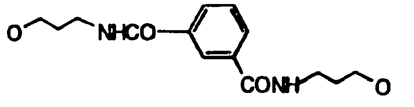 |
| C-24 | SCH₃ | 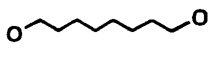 |
| C-25 | 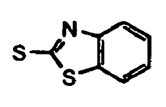 | 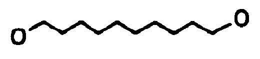 |
| C-26 | SCOCH₃ | 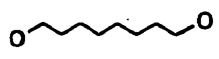 |
| C-27 | OSO₂CH₃ | 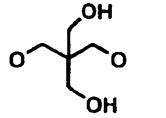 |
| C-28 | 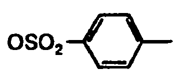 | 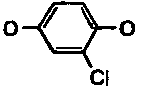 |
| C-29 | 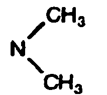 | 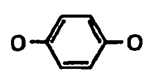 |
| C-30 | 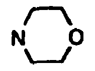 | 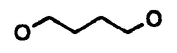 |
| C-31 | 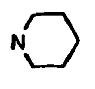 | 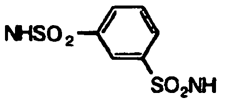 |
| C-32 | F | 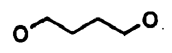 |
| C-33 | NHCOCH₃ | 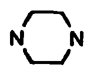 |
| C-34 | 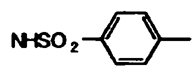 | 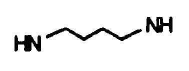 |
| C-35 | 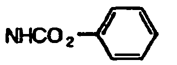 | 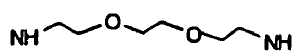 |

### (Group D)

**Table 4**

| | | |
|---|---|---|
| 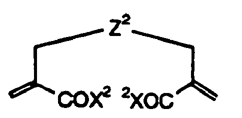 | | |

| No. | X² | Z² |
|---|---|---|
| D-1 | OCH₃ | 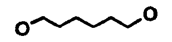 |
| D-2 | OCH₃ | 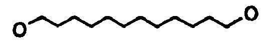 |
| D-3 | OC₂H₅ | 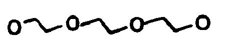 |
| D-4 | OC₂H₅ | 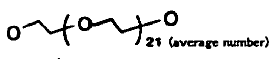 |
| D-5 | 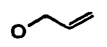 | 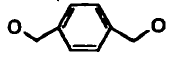 |
| D-6 | 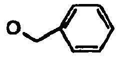 | 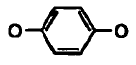 |
| D-7 | OCH₃ | 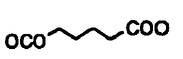 |
| D-8 | OCH₃ | 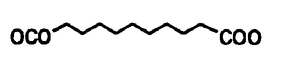 |
| D-9 | O(n)C₄H₉ | 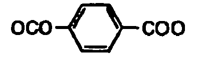 |
| D-10 | O(n)C₄H₉ | 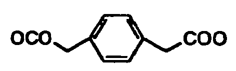 |
| D-11 | 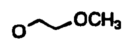 | 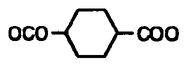 |
| D-12 | 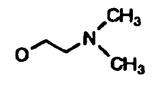 | 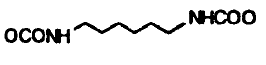 |
| D-13 | OCH₃ | 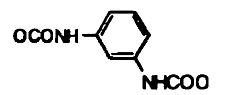 |
| D-14 | OCH₃ | 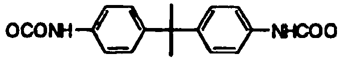 |
| D-15 | OCH₃ | 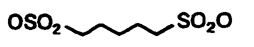 |
| D-16 | O(n)C₁₂H₂₆ | 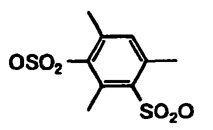 |
| D-17 | OCH₃ | 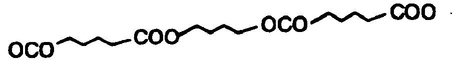 |
| D-18 | OCH₃ | 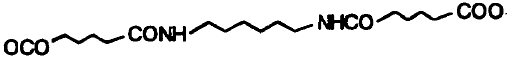 |
| D-19 | OCH₃ | 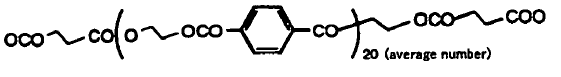 |
| D-20 | OC₂H₅ | 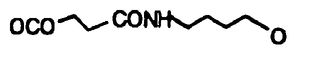 |
| D-21 | OCH₃ | 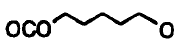 |
| D-22 | SCH₃ | 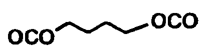 |
| D-23 | 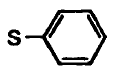 | 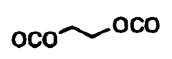 |
| D-24 | 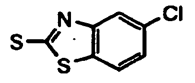 | 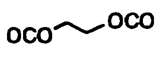 |
| D-25 | 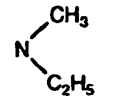 | 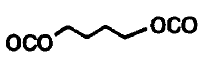 |
| D-26 | 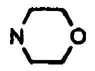 | 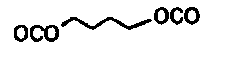 |
| D-27 | NH(n)C₁₂H₂₅ | 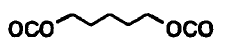 |
| D-28 | OCH₃ | 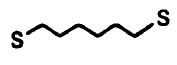 |
| D-29 | 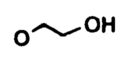 | 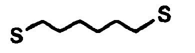 |
| D-30 | 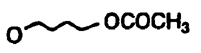 | 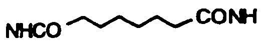 |
| D-31 | OCH₃ | 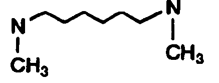 |
| D-32 | OCH₃ | 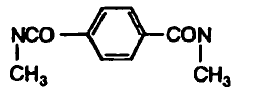 |
| D-33 | OCH₃ | 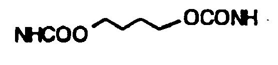 |
| D-34 | OCH₃ | 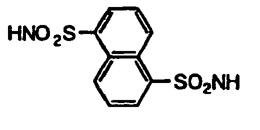 |
| D-35 | OC₂H₅ | O |

### iii) Trifunctional or Higher Compounds

### (Group E)

**Table 5**

| | | |
|---|---|---|
| 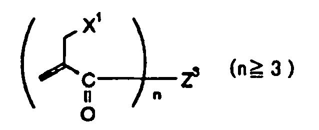 | | |

| No. | X¹ | Z³ |
|---|---|---|
| E-1 | OH | 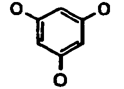 |
| E-2 | OCH₃ | 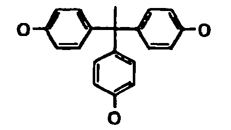 |
| E-3 | OCOCH₃ | 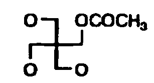 |
| E-4 | OH | 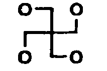 |
| E-5 | OCOCH₃ | 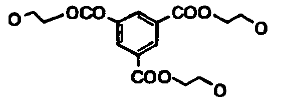 |
| E-6 | 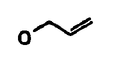 | 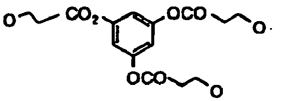 |
| E-7 | OH | 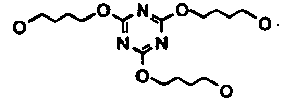 |
| E-8 | OH | 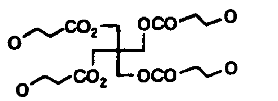 |
| E-9 | OH | 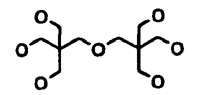 |
| E-10 | OCOCH₃ | 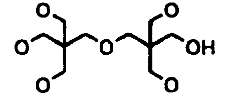 |
| E-11 | SCH₃ | 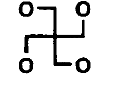 |
| E-12 | Cl | 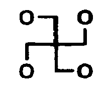 |
| E-13 | Br | 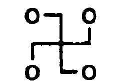 |
| E-14 | 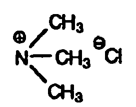 | 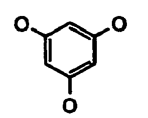 |
| E-15 | 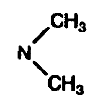 | 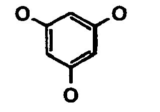 |
| E-16 | 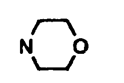 | 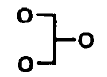 |
| E-17 | OCO(n)C₁₂H₂₅ | 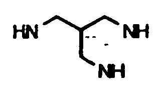 |
| E-18 | 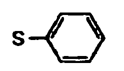 | 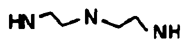 |
| E-19 | 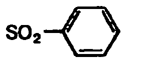 | 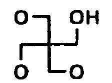 |
| E-20 | 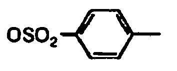 | 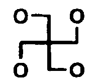 |
| E-21 | NHCOCH₃ | 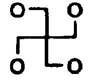 |
| E-22 | 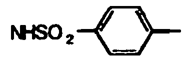 | 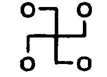 |
| E-23 | 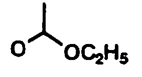 | 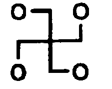 |
| E-24 | 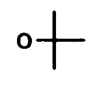 | 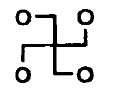 |
| E-25 | OH | 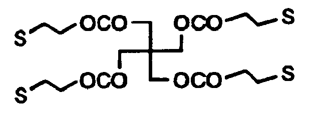 |
| E-26 | OH | 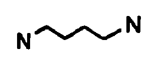 |

### (Group F)

**Table 6**

| | | |
|---|---|---|
| 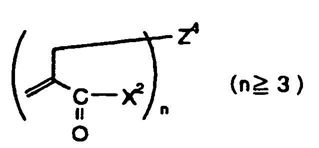 | | |

| No. | X² | Z⁴ |
|---|---|---|
| F-1 | OH | 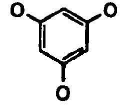 |
| F-2 | OCH₃ | 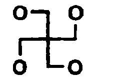 |
| F-3 | OOH₃ | 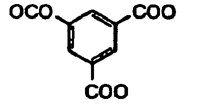 |
| F-4 | OCH₃ | 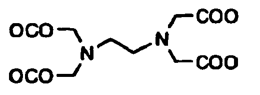 |
| F-5 | OC₂H₅ | 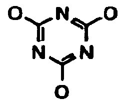 |
| F-6 | OOH₃ | 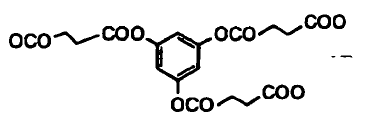 |
| F-7 | OCH₃ | 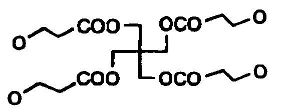 |
| F-8 | O(n)C₃H₇ | 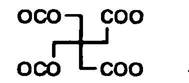 |
| F-9 | 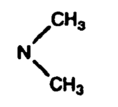 | 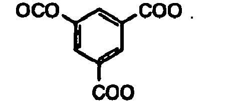 |
| F-10 | O(n)C₁₂H₂₅ | 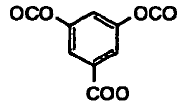 |
| F-11 | 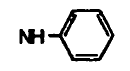 | 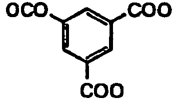 |
| F-12 | NH-(n)O₄N | 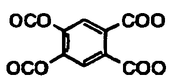 |
| F-13 | Cl | 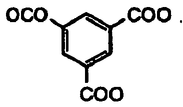 |
| F-14 | O^{⊖}Na^{⊕} | 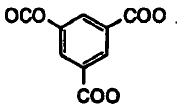 |
| F-15 | 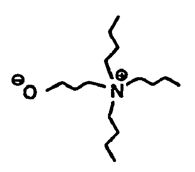 | 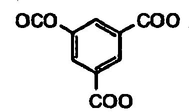 |
| F-16 | OCH₃ | 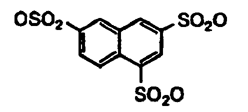 |
| F-17 | OCH₃ | 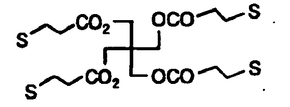 |
| F-18 | OCH₃ | 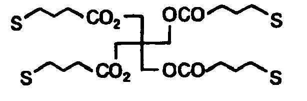 |
| F-19 | 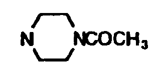 | 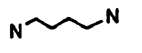 |
| F-20 | 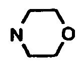 | 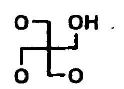 |
| F-21 | OCH₃ | 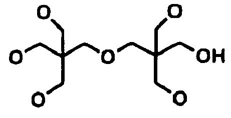 |
| F-22 | 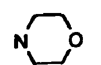 | 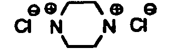 |

### iv) Polymeric Compounds

### (Group G)

| | | |
|---|---|---|
| G-1 | 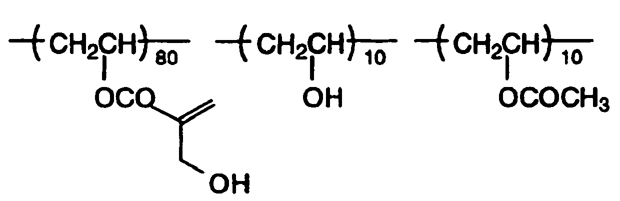 | Mw 20000 |
| G-2 | 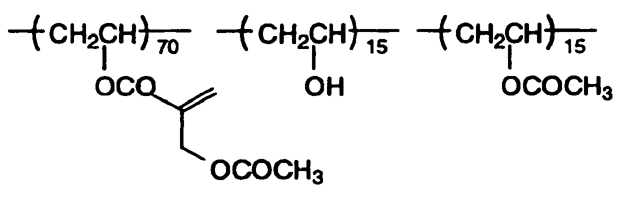 | Mw 15000 |
| G-3 | 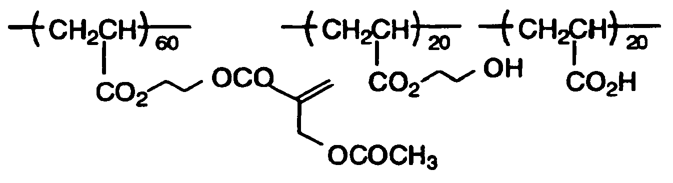 | Mw 30000 |
| G-4 | 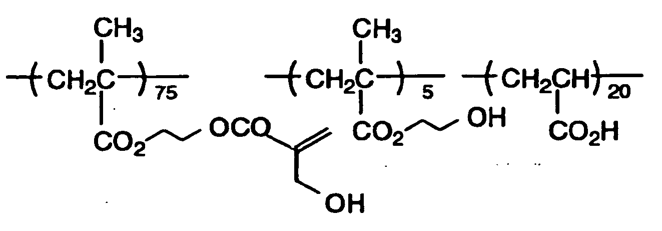 | Mw 50000 |
| G-5 | 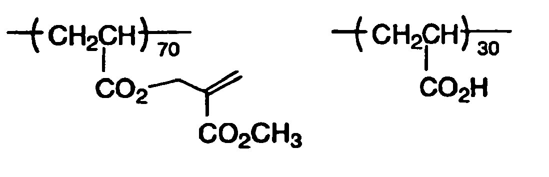 | Mw 20000 |
| G-6 | 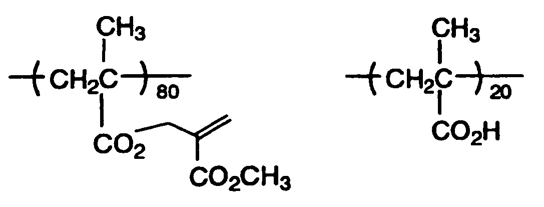 | Mw 10000 |
| G-7 | 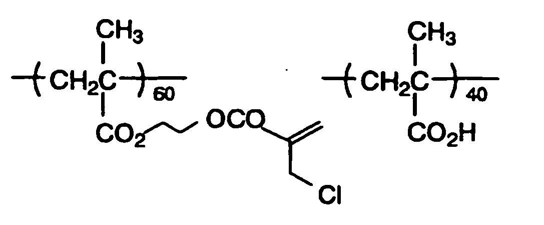 | Mw 20000 |
| G-8 | 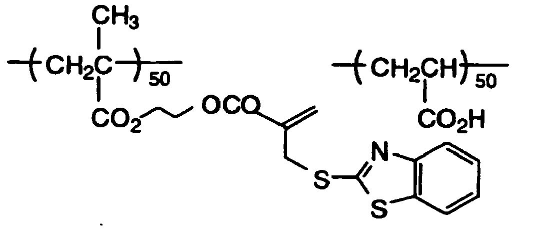 | Mw 20000 |
| G-9 | 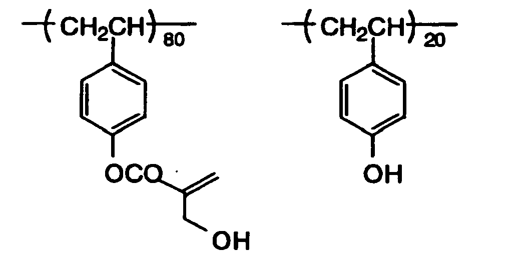 | Mw 5000 |
| G-10 | 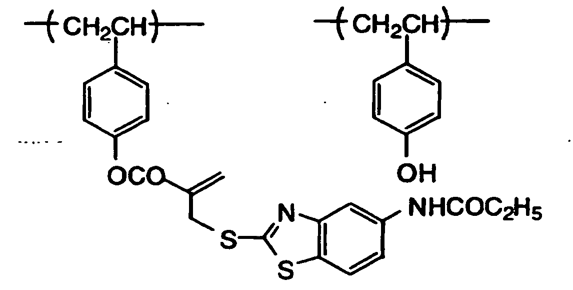 | Mw 10000 |
| G-11 | 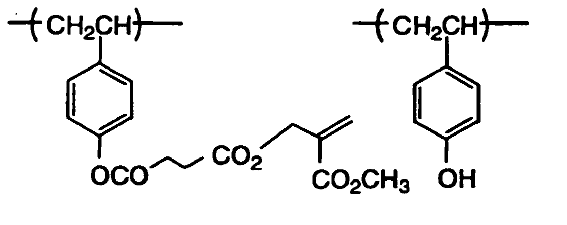 | Mw 10000 |
| G-12 | 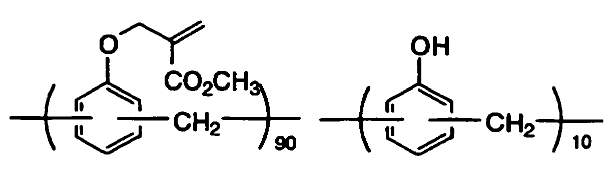 | Mw 5000 |
| G-13 | 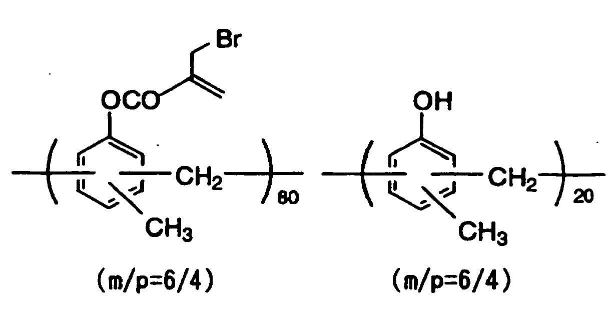 | Mw 7500 |
| G-14 | 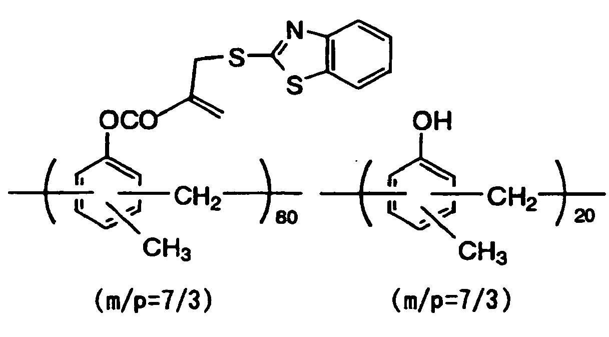 | Mw 4000 |
| G-15 | 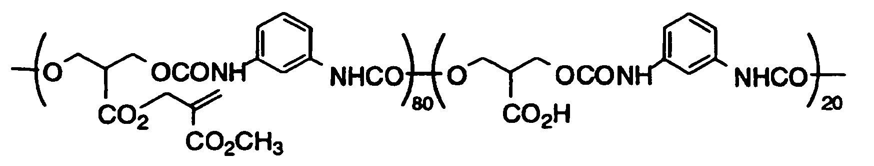 | Mw 10000 |
| G-16 | 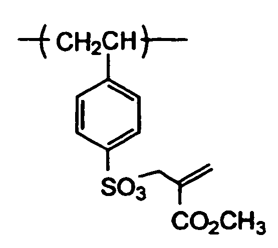 | Mw 100000 |
| G-17 | 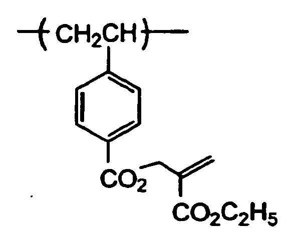 | Mw 15000 |
| G-18 | 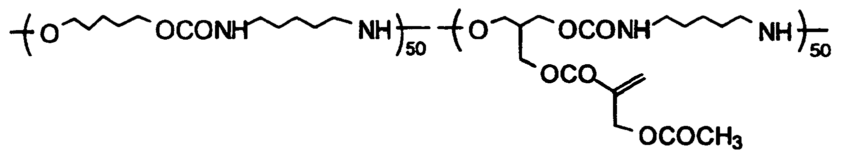 | Mw20000 |
| G-19 | 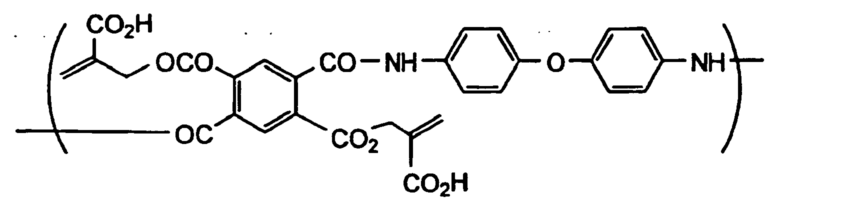 | Rw 15000 |
| G-20 | 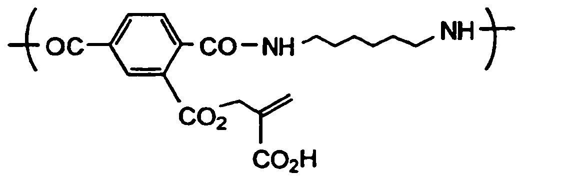 | Mw 5000 |
| G-21 | 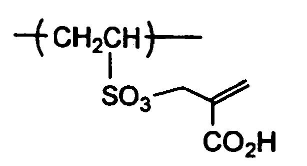 | Mw 20000 |
| G-22 | 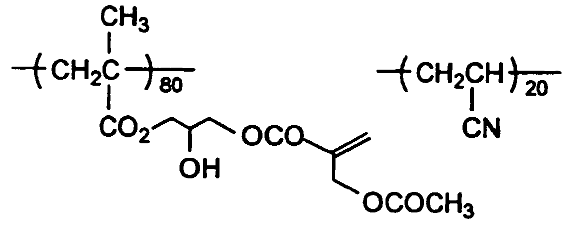 | Mw 30000 |
| G-23 | 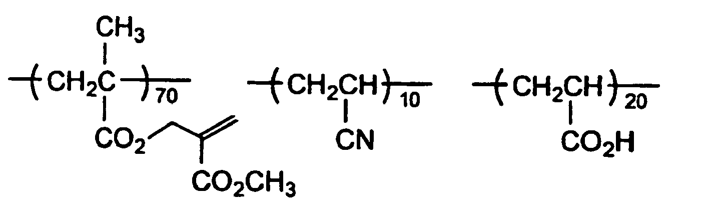 | Mw 30000 |
| G-24 | 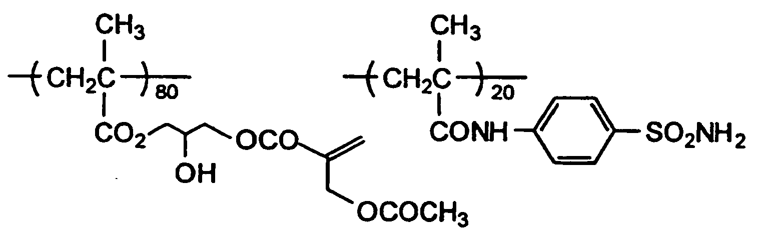 | Mw 20000 |
| G-25 | 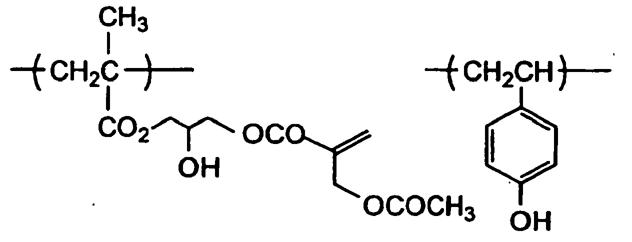 | Mw 15000 |
| G-26 | 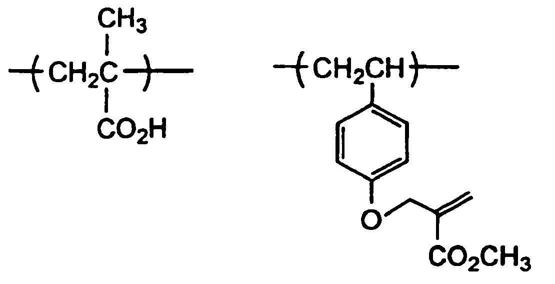 | Mw 10000 |

### v) Others

### (Group H)

| | |
|---|---|
| H-1 | 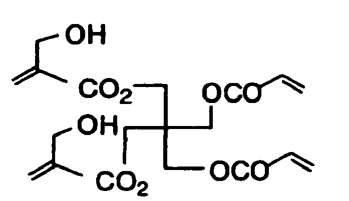 |
| H-2 | 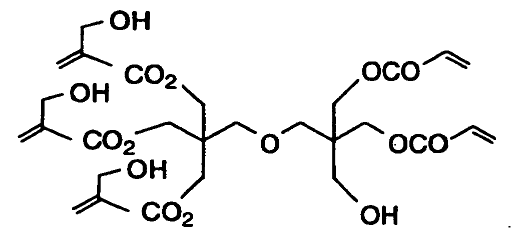 |
| H-3 | 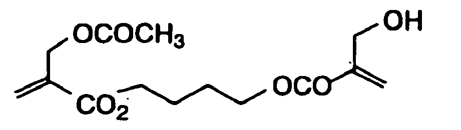 |
| H-4 | 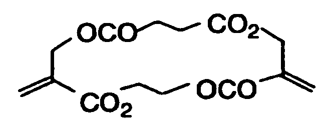 |
| H-5 | 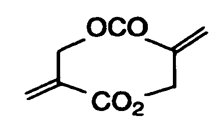 |
| H-6 | 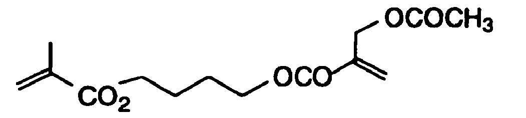 |
| H-7 | 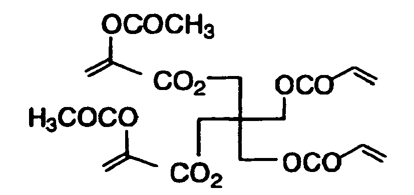 |

### (Group J)

| | |
|---|---|
| J-1 | 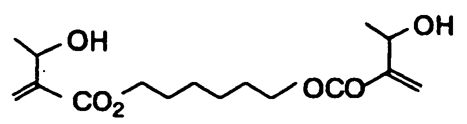 |
| J-2 | 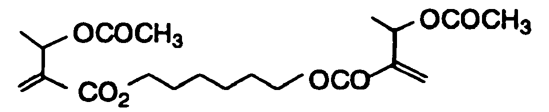 |
| J-3 | 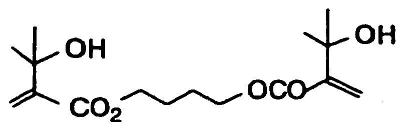 |
| J-4 | 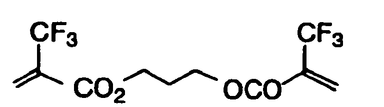 |
| J-5 | 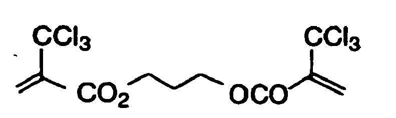 |
| J-6 | 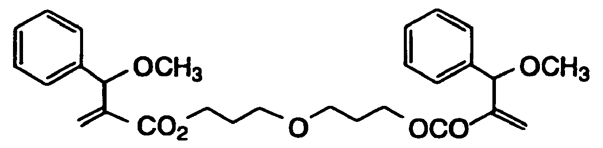 |
| J-7 | 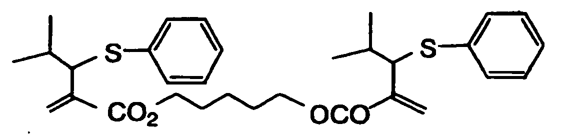 |
| J-8 | 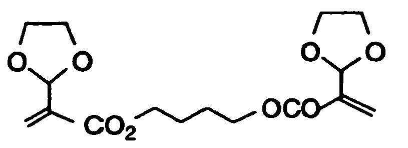 |
| J-9 | 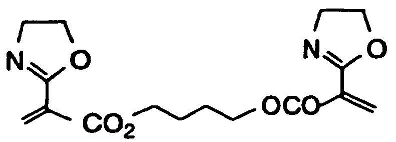 |
| J-10 | 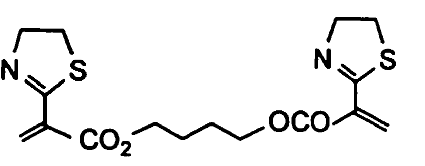 |
| J-11 | 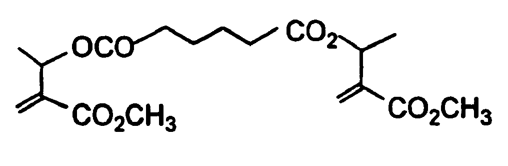 |
| J-12 | 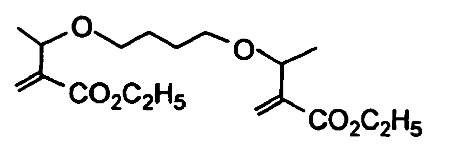 |
| J-13 | 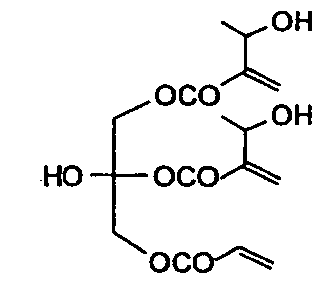 |
| J-14 | 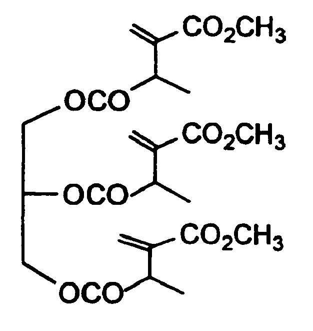 |
| J-15 | 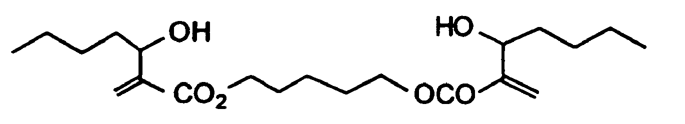 |

### vi) Monofunctional Compounds

### (Group A')

**Table 7**

| | |
|---|---|
| 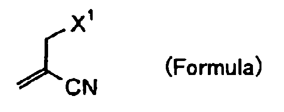 | |

| No. | X¹ |
|---|---|
| A'-1 | OH |
| A'-2 | OCH₃ |
| A'-3 | 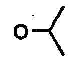 |
| A'-4 | O(n)C₈H₁₇ |
| A'-5 | 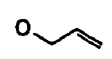 |
| A'-6 | 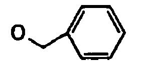 |
| A'-7 | 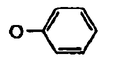 |
| A'-8 | 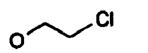 |
| A'-9 | 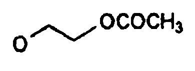 |
| A'-10 | 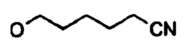 |
| A'-11 | OCOCH₃ |
| A'-12 | OCO(n)C₆H₁₃ |
| A'-13 | 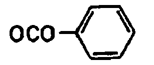 |
| A'-14 | -OSO₂CH₃ |
| A'-15 | OSO₂(n)C₄H₉ |
| A'-16 | 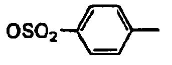 |
| A'-17 | OSO₂CF₃ |
| A'-18 | SCH₃ |
| A'-19 | S(n)C₄H₉ |
| A'-20 | 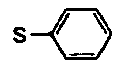 |
| A'-21 | 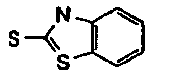 |
| A'-22 | 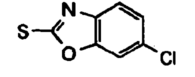 |
| A'-23 | F |
| A'-24 | Cl |
| A'-25 | Br |
| A'-26 | I |
| A'-27 | 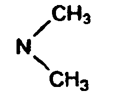 |
| A'-28 | 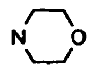 |
| A'-29 | 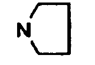 |
| A'-30 | 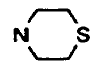 |
| A'-31 | 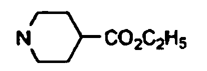 |
| A'-32 | 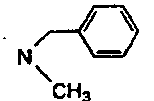 |
| A'-33 | 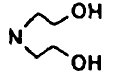 |
| A'-34 | 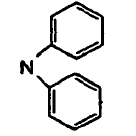 |
| A'-35 | 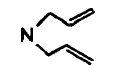 |
| A'-36 | NHCOCH₃ |
| A'-37 | NHCO(n)C₄H₉ |
| A'-38 | 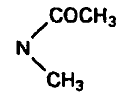 |
| A'-39 | NHSO₂CH₃ |
| A'-40 | 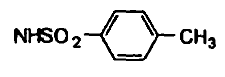 |
| A'-41 | OCOCH₃ |
| A'-42 | 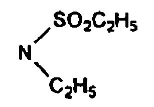 |
| A'-43 | 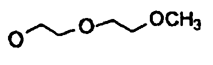 |
| A'-44 | 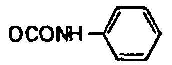 |
| A'-45 | 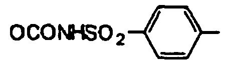 |
| A'-46 | 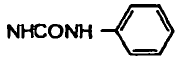 |
| A'-47 | NHCO₂(n)C₆H₁₃ |
| A'-48 | OCSNH(n)C₄H₉ |

### vii) Difunctional Compounds

### (Group B')

**Table 8**

| | |
|---|---|
| 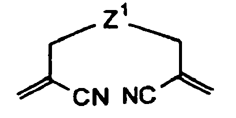 | |

| No. | Z¹ |
|---|---|
| | |
| B'-1 | 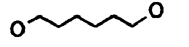 |
| B'-2 | 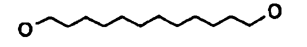 |
| B'-3 | 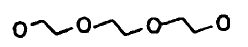 |
| B'-4 | 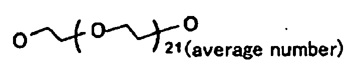 |
| B'-5 | 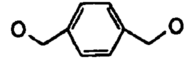 |
| B'-6 | 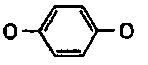 |
| B'-7 | 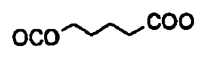 |
| B'-8 | 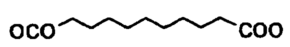 |
| B'-9 | 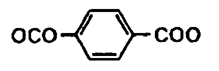 |
| B'-10 | 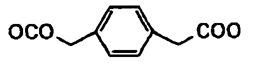 |
| B'-11 | 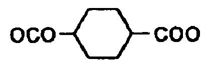 |
| B'-12 | 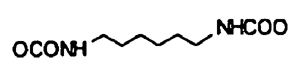 |
| B'-13 | 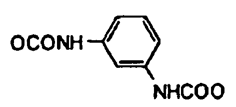 |
| B'-14 | 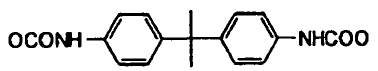 |
| B'-15 | 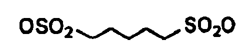 |
| B'-16 | 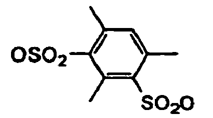 |
| B'-17 | 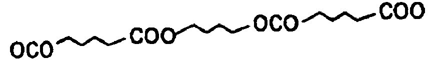 |
| B'-18 | 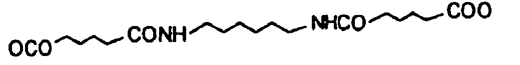 |
| B'-19 | 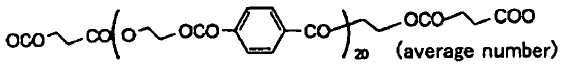 |
| B'-20 | 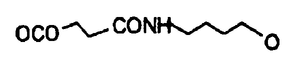 |
| B'-21 | 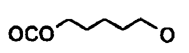 |
| B'-22 | 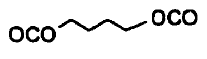 |
| B'-23 | 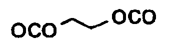 |
| B'-24 | 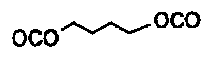 |
| B'-25 | 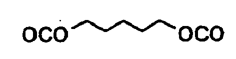 |
| B'-26 | 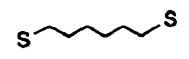 |
| B'-27 | 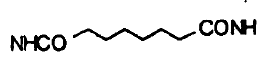 |
| B'-28 | 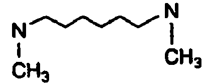 |
| B'-29 | 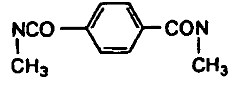 |
| B'-30 | 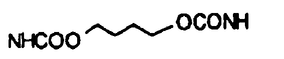 |
| B'-31 | 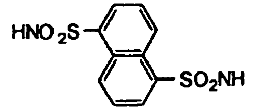 |

### viii) Multifunctional Compounds

### (Group C')

**Table 9**

| | |
|---|---|
| 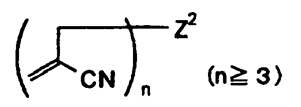 | |

| No. | Z² |
|---|---|
| C'-1 | 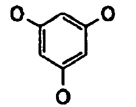 |
| C'-2 | 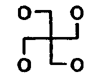 |
| C'-3 | 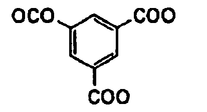 |
| C'-4 | 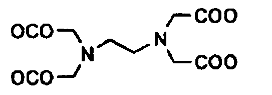 |
| C'-5 | 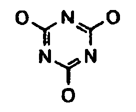 |
| C'-6 | 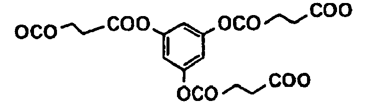 |
| C'-7 | 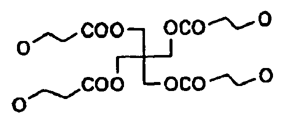 |
| C'-8 | 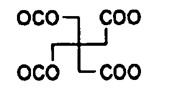 |
| C'-9 | 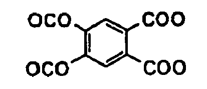 |
| C'-10 | 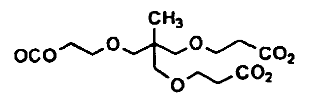 |
| C'-11 | 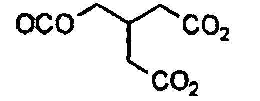 |
| C'-12 | 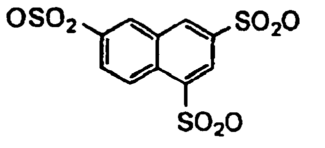 |
| C'-13 | 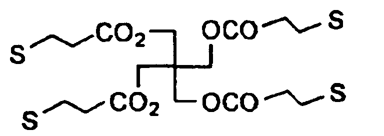 |
| C'-14 | 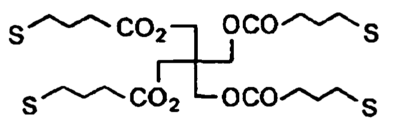 |
| C'-15 | 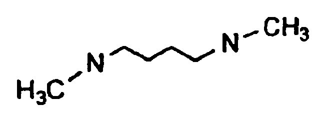 |
| C'-16 | 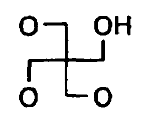 |
| C'-17 | 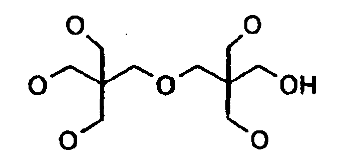 |
| C'-18 | 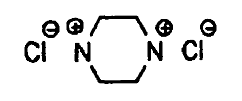 |

### ix) Polymeric Compounds

### (Group G')

| | | |
|---|---|---|
| G'-1 | 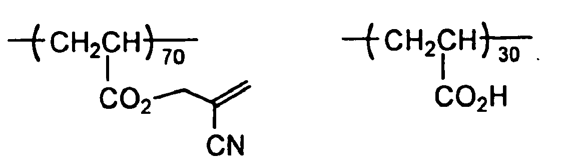 | Mw 50000 |
| G'-2 | 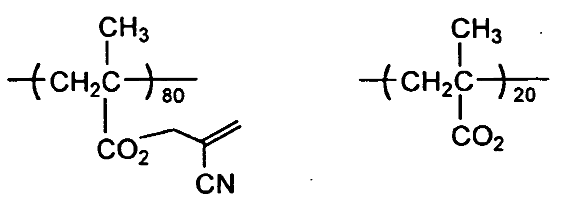 | Mw 50000 |
| G'-3 | 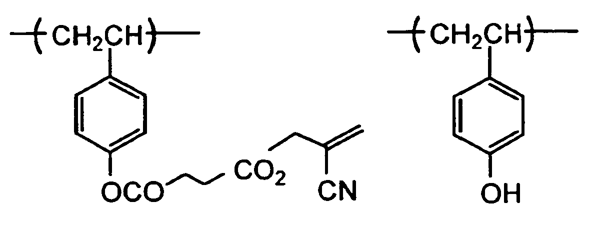 | Mw 10000 |
| G'-4 | 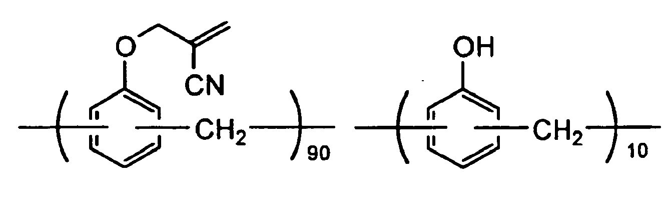 | Mw 5000 |
| G'-5 | 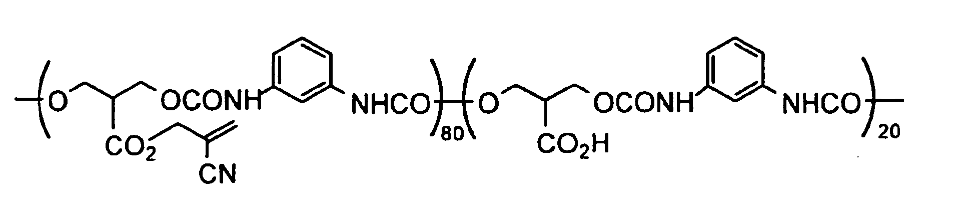 | Mw 30000 |
| G'-6 | 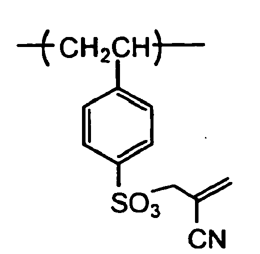 | Mw 100000 |
| G'-7 | 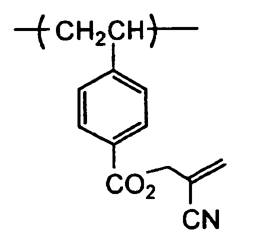 | Mw 15000 |
| G'-8 | 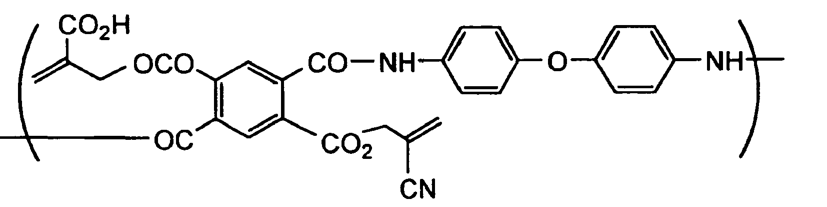 | Mw 15000 |
| G'-9 | 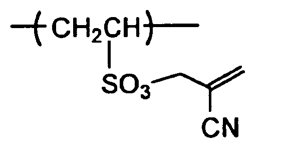 | Mw 20000 |
| G'-10 | 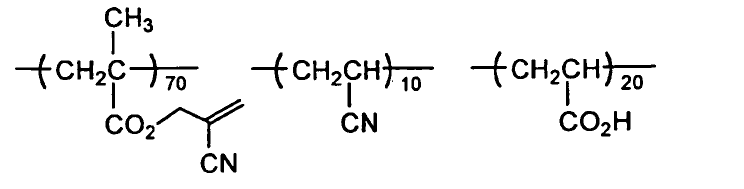 | Mw 30000 |
| G'-11 | 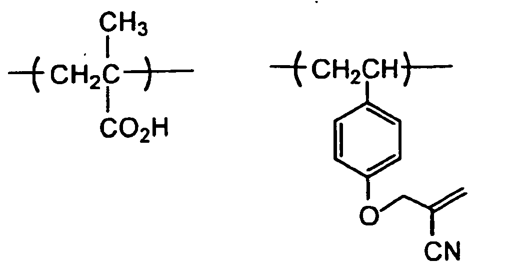 | Mw 10000 |

In the present ink composition, α-heteromethacrylic compounds according to the invention are used in an amount of preferably 5 to 95 % by weight, more preferably 15 to 85 % by weight.

Additionally, polymerizing compounds other than the α-heteromethacrylic compounds as recited above may also be used in the present ink composition. For instance, monoacrylate compounds, multifunctional acrylate monomers and multifunctional acrylate oligomers can be used in combination with the α-heteromethacrylic compounds. Examples of the other polymerizing compounds include isomyristyl acrylate, isostearyl acrylate, lauryl acrylate, isoamyl acrylate, stearyl acrylate, ethoxy-diethylene glycol, methoxy-polyethylene glycol, methoxydipropylene glycol acrylate, 2(2-ethoxyethoxy)ethyl acrylate, butoxyethyl acrylate, isobornyl acrylate, phenoxy-polyethylene glycol acrylate, 2-ethylhexyl-diglycol acrylate, 2-acryloyloxyethyl phthalate, 2-acryloyloxyethyl-2-hydroxyethyl phthalate, ethoxylated phenyl acrylate, 2-acryloyloxyethyl succinate, acrylate of nonyl phenyl-ethylene oxide adduct, 2-acryloyloxyethyl hexahydrophthalate, lactone-modified flexible acrylate, polytetramethylene glycol diacrylate, tetraethylene glycol diacrylate, hydroxypivalic acid neopentyl glycol diacrylate, dimethyloltricyclodecane diacrylate, dimethyloldicyclopentane diarylate, an adduct formed between propylene glycol diglycidyl ether and acrylic acid, an adduct formed between bisphenol A diglycidyl ether and (meth)acrylic acid, modified bisphenol A diacrylates such as bisphenol A-propylene oxide adduct diacrylate and bisphenol A-ethylene oxide adduct diacrylate, glycerol propoxytriacrylate, pentaerythritol tetraacrylate, pentaerythritol ethoxytetraacrylate, dipentaerithritol hexaacrylate, caprolactone-modified dipentaerythritol hexaacrylate, ethylene oxide-modified trimethylolpropane triacrylate, caprolactone-modified trimethylolpropane triacrylate, ditrimethylolpropane tetraacrylatae, amine-modified polyester tetraacrylate, urethane prepolymer prepared from pentaerythritol triacrylate and tolylene diisocyanate, and uretane prepolymer prepared from pentaerythritol triacrylate and hexamethylene diisocyanate. In addition, these polymerizing compounds may be used in combination with other polymerizing monomers or oligomers having molecular weights of 400 or above (e.g., acrylate monomers or oligomers having molecular weights of 400 or above). As to the other polymerizing compounds recited above, it is preferable to use at least one compound selected from isomyristyl acrylate, isostearyl acrylate, lauryl acrylate, isoamyl acrylate, stearyl acrylate, ethoxy-diethylene glycol acrylate, methoxy-polyethylene glycol acrylate, methoxydipropylene glycol acrylate, 2(2-ethoxyethoxy)ethyl acrylate or lactone-modified flexible acrylate.

In the combined use with the present α-heteromethacrylic compounds, it is appropriate that an amount of the other polymerizing compounds as recited above is preferably 5 to 85 weight %, more preferably 5 to 70 weight %, of all the polymerizing compounds used.

### <<Coloring Material>>

Coloring materials usable in the invention are described below.

As to the coloring materials used in the invention, there is no particular restriction. Although pigments superior in weather resistance are preferable, any of known coloring materials including soluble dyes and fat dyes may be used in the invention.

Pigments that are preferably used in the invention are described. In the present ink composition, it is possible to use pigments not yet in the actual use for inkjet ink because their color formability (color density per concentration of pigments added) is not always high, and besides, they are difficult to make into homogeneous fine-grain dispersions and therefore suffer a phenomenon that their use in high concentrations causes excessive increase in melt viscosity. For instance, the following organic and inorganic pigments having the numbers assigned in Color Index are usable though the invention imposes no particular limitation on pigments to be used.

Examples of red or magenta pigments include Pigment Red 3, 5, 19, 22, 31, 38, 43, 48:1, 48:2, 48:3, 48:4, 48:5, 49:1, 53:1, 57:1, 57:2, 58:4, 63:1, 81, 81:1, 81:2, 81:3, 81:4, 88, 104, 108, 112, 122, 123, 144, 146, 149, 166, 168, 169, 170, 177, 178, 179, 184, 185, 208, 216, 226 and 257. Examples of violet pigments include Pigment Violet 3, 19, 23, 29, 30, 37, 50 and 88, and those of orange pigments include Pigment Orange 13, 16, 20 and 36. Examples of blue or cyan pigments include Pigment Blue 1, 15, 15:1, 15:2, 15:3, 15:4, 15:6, 16, 17-1, 22, 27, 28, 29, 36 and 60, and those of green pigments include Pigment Green 7, 26, 36 and 50. Examples of yellow pigments include Pigment Yellow 1, 3, 12, 13, 14, 17, 34, 35, 37, 55, 74, 81, 83, 93, 94, 95, 97, 108, 109, 110, 137, 138, 139, 153, 154, 155, 157, 166, 167, 168, 180, 185 and 193. Examples of black pigments include Pigment Black 7, 28 and 26, and those of white pigments include Pigment White 6, 18 and 21. From these pigments, appropriate ones can be selected according to the desired purpose.

For dispersing pigments can be used various types of dispersing apparatus, such as a ball mill, a sand mill, an attrition mill, a roll mill, an agitation mill, Henschel mixer, a colloid mill, an ultrasonic homogenizer, a pearl mill, a wet jet mill and a paint shaker. In addition, it is possible to add a dispersant on the occasion when pigments are dispersed. The dispersant added has no particular restriction as to its kind, but it is preferable to use a polymeric dispersant. Examples of a polymeric dispersant usable herein include Solsperse Series manufactured by Zeneca Inc. Further, it is also possible to use as dispersing aids a wide variety of synergists appropriate to the pigments used. These dispersants and dispersing aids are preferably added in an amount of 1 to 50 parts by weight per 100 parts by weight of pigments. Although the dispersing medium can be solvents or polymerizing compounds according to the invention, the radiation-curable ink used in the invention prefers containing no solvent because it is required to undergo reaction and be cured immediately after it impacts against a recording material. The solvents remaining in the cured images produce a problem of causing deterioration in solvent resistance and a problem about volatile organic compounds (VOC) therein. From the viewpoint of dispersion suitability, therefore, it is preferable to choose as the dispersing medium a polymerizing compound, especially a monomer having the lowest viscosity, but not a solvent.

The selection of a pigment, a dispersant and a dispersing medium and the setting of conditions for dispersion and filtration are determined so that the pigment particles preferably have their average size in the range of 0.08 to 0.5 µm and the maximum size in the range of 0.3 to 10 µm, preferably 0.3 to 3 µm. By such a particle-size control, clogging of head nozzles can be prevented and storage stability, transparency and curing sensitivity of the ink can be maintained: Further, it is appropriate that the proportion of a coloring material added in the total ink be from 1 to 10 % by weight, preferably 2 to 8 % by weight.

In addition to the ingredients mentioned above, the present inkjet recording ink composition can contain other ingredients as required.

When electron beams or X-rays are used as irradiation light, no polymerization initiator is required. On the other hand, the use of ultraviolet light (UV light), visible light or infrared light as a light source requires addition of radical polymerization initiators, polymerization initiation assistants and sensitizing dyes appropriate to wavelengths of the light source used. As the polymerization initiators, various known compounds can be used, but it is preferable to select them from compounds capable of dissolving the polymerizing compounds relating to the invention. Examples of compounds suitable as polymerization initiators include polymerization initiators of xanthone or thioxanthone type, polymerization initiators of benzophenone type, polymerization initiators of quinone type and polymerization initiators of phosphine oxide type.

From the viewpoint of enhancing the keeping quality, it is appropriate that 200 to 20,000 ppm of a polymerization inhibitor be further added. Since it is preferable to eject the present inkjet recording ink in a state that the ink is lowered in viscosity by heating at temperatures ranging from 40°C to 80°C, the addition of a polymerization inhibitor is favorable for prevention of head clogging by thermal polymerization. Examples of a polymerization inhibitor usable herein include hydroquinone, benzoquinone, p-methoxyphenol, TEMPO, TEMPOL and cupferron Al.

### <<Others>>

In addition, known compounds can be used as required. For instance, surfactants, leveling additives, matting agents, and substances for adjustment of film properties, such as polyester resin, polyurethane resin, vinyl resin, acrylic resin, rubber resin and wax, can be used as appropriate. Moreover, addition of a non-polymerization-inhibiting tackifier is favorable for improvement in adhesiveness to recording materials, such as polyolefin and PET. More specifically, the high-molecular-weight, tacky polymers as disclosed in JP-A-2001-49200, pp. 5-6, including copolymers of 1-20C alkyl group-containing alcohol esters of (meth)acrylic acid, 2-14C alicyclic alcohol esters of (meth)acrylic acid and 6-14C aromatic alcohol esters of (meth)acrylic acid, and low-molecular-weight, tackiness-imparting resins having polymerizing unsaturated bonds can be used as tackifiers.

In improving adhesiveness to a recording material, it is also effective to add a trace amount of organic solvent. In this case, the addition within the bounds of no problems about solvent resistance and VOC is effective, and the organic solvent content in the whole ink composition is preferably from 0.1 to 5 % by weight, far preferably from 0.1 to 3 % by weight.

As a hedge against sensitivity drop by the light-shielding effect of coloring materials in ink, conversion to a radical-cation hybrid cure ink by combining a polymerization initiator with a monomer capable of undergoing cationic polymerization and being long in polymerization initiator life is one of preferred embodiments of the present ink composition, too.

In view of ejectability, it is appropriate that the present ink composition have ink viscosity of 7 to 30 mPa·s, preferably 7 to 20 mPa·s, at the ejection-time temperature. So, it is preferable that the proportions of constituents in the ink composition are determined properly so as to control the ink viscosity to within the forgoing range. Incidentally, the ink viscosity at temperatures ranging from 25°C to 30°C is from 35 to 500 mPas, preferably from 35 to 200 spas. By adjusting the ink viscosity at room temperature to a high value, ink permeation into a recording material can be prevented even when the recording material is porous, and thereby reduction in monomer molecules remaining without receiving curing reaction and the control of a bad smell become possible, and besides, the dot spread upon impact of ink droplets against the recording material can be lessened. As a result, image quality can be improved. The ink viscosity lower than 35 mPa·s at 25-30°C produces little effect on prevention of dot spread, while the ink viscosity higher than 50 mPa·s at 25-30°C causes a problem with ink liquid delivery.

The surface tension of the present ink composition is preferably from 20 to 30 mN/m, far preferably from 23 to 28 mN/m. In the case of recording on various recording materials, such as polyolefin film, PET film, coated paper and uncoated paper, the suitable surface tension is 20 mN/m or above from the viewpoint of ink spread and permeation, but it is 30 mN/m or below from the viewpoint of wettability.

### <<Substrate>>

Substrates usable in the invention are described below.

The substrates used in the invention are not particularly restricted as to their kinds so long as they are dimensionally stable sheet-form hydrophilic substrates. Examples of a substrate usable in the invention include paper, plastic-laminated paper (such as polyethylene-, polypropylene- or polystyrene-laminated paper), a sheet of metal (e.g., aluminum, zinc, copper), a film of plastic (such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper and plastic films on which the metals as recited above are laminated or evaporated. Of these substrates, a polyester film and an aluminum sheet are preferred over the others. In terms of superiority in dimensional stability and moderate price, an aluminum sheet is especially advantageous.

The aluminum sheet is a pure aluminum sheet, an alloy sheet containing aluminum as a major component and trace amounts of foreign elements, or a thin film of pure aluminum or aluminum alloy on which a plastic is laminated. Examples of foreign elements contained in aluminum alloys include silicon, iron, manganese, copper, magnesium, chromium, zinc, bismuth, nickel and titanium. The content of those foreign metals in aluminum alloy is up to 10 % by weight. Although pure aluminum is preferable in the invention, absolutely pure aluminum is difficult to produce from a technological viewpoint of smelting, so aluminum containing foreign elements in small amounts may be used. The aluminum sheet has no particular restrictions as to the composition thereof, and any of the known materials approved officially can be utilized as appropriate.

The thickness of the substrate as recited above is preferably from 0.1 to 0.6 mm, far preferably from 0.15 to 0.4 mm.

Before using such an aluminum sheet, the aluminum sheet is preferably subjected to surface treatments, such as surface-roughening treatment and anodic oxidation treatment. These treatments can render the aluminum sheet surface highly hydrophilic and can make it easy to ensure sufficient adhesion to an image-recording layer. Before undergoing the surface-roughening treatment, the aluminum sheet is subjected to degreasing treatment with a surfactant, an organic solvent or an alkaline aqueous solution for removal of rolling oil from the aluminum sheet surface, if needed.

The surface-roughening treatment of an aluminum sheet can be carried out using various methods. For instance, mechanical surface-roughening treatment, electrochemical surface-roughening treatment (surface-roughening treatment through electrochemical dissolution of the aluminum sheet surface), or chemical surface-roughening treatment (a method of selectively dissolving the surface through chemical action) can be adopted.

As the mechanical surface-roughening method, known methods including a ball graining method, a brush graining method, a blast graining method and a buff graining method can be adopted. Alternatively, it is acceptable to adopt a transfer method of using a roll having an uneven surface profile and transferring its unevenness to an aluminum sheet surface at the rolling stage of aluminum.

As to the electrochemical surface-roughening method, there is a method of roughening the surface of an aluminum sheet in an electrolytic solution containing an acid, such as hydrochloric acid or nitric acid, by passing AC or DC current through the electrolytic solution. In addition, as disclosed in JP-A-54-63902, the electrolytic surface-roughening method using a mixed acid can also be used.

The thus surface-roughened aluminum sheet is subjected to alkali etching treatment with an aqueous solution of potassium hydroxide or sodium hydroxide and further to neutralizing treatment, if needed, and then to anodic oxidation treatment, if desired for enhancing abrasion resistance.

As electrolytes used for the anodic oxidation treatment of an aluminum sheet, various electrolytes capable of forming porous oxide coating can be used. In general, sulfuric acid, hydrochloric acid, oxalic acid, chromic acid and mixed acids of two or more thereof can be used as such electrolytes. The suitable electrolyte concentration can be determined properly depending on the kind of an electrolyte used.

Conditions for anodic oxidation treatment vary with electrolytes used, so they cannot be specified sweepingly. In general, however, it is appropriate that the electrolyte concentration in an electrolytic solution be from 1 to 80 % by weight, the electrolytic solution temperature be from 5 to 70°C, the current-density be from 5 to 60 amperes/dm², the voltage be from 1 to 100 V, and the electrolysis time be from 10 sec. to 5 min. The suitable quantity of an anodic oxide coating formed is from 1.0 to 5.0 g/m², particularly from 1.5 to 4.0 g/m². In such a quantity range, the anodic oxide coating can provide a sufficient press life and a satisfactory scratch resistance in non-image areas of a lithographic printing plate.

The substrate that has been subjected to the foregoing surface treatments and further provided with an anodic oxide coating may be used in the invention as it is. However, with the intention of further improving adhesion to the upper layer, water wettability, scumming resistance and thermal insulation, such a substrate can undergo an additional treatment chosen appropriately from the treatment for enlarging or sealing micropores of the anodic oxide coating or the treatment for imparting water wettability to the surface by immersion into an aqueous solution of hydrophilic compounds as disclosed in JP-A-2001-253181 and JP-A-2001-322365. It goes without saying that those enlarging and sealing treatments should not be construed as being limited to the treatments disclosed in the documents cited above, but any of known methods can be applied thereto.

### <Treatment for Sealing of Anodic Oxide Coating>

Examples of sealing treatment which can achieve the foregoing intention include steam sealing, treatment with fluorozirconic acid alone, sealing with an aqueous solution containing an inorganic fluorine compound, such as sodium fluoride, sealing with lithium chloride-added steam, and hot water sealing.

Of these sealing treatments, sealing with an aqueous solution containing an inorganic fluorine compound, steam sealing and hot water sealing are advantageous. Each of these treatments are described below.

### <Sealing with Aqueous Solution containing Inorganic fluorine Compound>

As the inorganic fluorine compound used in sealing treatment with an aqueous solution containing an inorganic fluorine compound, a metal fluoride, for example, is suitable.

Examples of such an inorganic fluorine compound include sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, fluorozirconic acid, fluorotitanic acid, hexafluorosilicic acid, nickel fluoride, iron fluoride, fluorophosphoric acid and ammonium fluorophosphate. Of these compounds, sodium fluorozirconate, sodium fluorotitanate, fluorozirconic acid and fluuorotitanic acid are preferred over the others.

From the viewpoint of adequately sealing micropores in anodic oxide coating, the inorganic fluorine compound concentration in the aqueous solution is preferably at least 0.01 % by weight, far preferably at least 0.05 % by weight, and in terms of scumming resistance it is preferably at most 1 % by weight, far preferably at most 0.5 % by weight.

It is preferable that the aqueous solution containing an inorganic fluorine compound further contains a phosphate compound. Addition of a phosphate compound enhances water-receptivity of the surface of an anodic oxide coating, and thereby on-machine developability and scumming resistance can be improved.

As the phosphate compound, a metal phosphate, such as an alkali metal phosphate or an alkaline earth metal phosphate, is suitable.

Examples of such a phosphate compound include zinc phosphate, aluminum phosphate, ammonium phosphate, diammonium hydrogen phosphate, ammonium dihydrogen phosphate, monoammonium phosphate, monopotassium phosphate, monosodium phosphate, potassium dihydrogen phosphate, dipotassium hydrogen phosphate, calcium phosphate, ammonium sodium hydrogen phosphate, magnesium hydrogen phosphate, magnesium phosphate, ferrous phosphate, ferric phosphate, sodium dihydrogen phosphate, sodium phosphate, disodium hydrogen phosphate, lead phosphate, diammonium phosphate, calcium dihydrogen phosphate, lithium phosphate, phosphotungstic acid, ammonium phosphotungstate, sodium phosphotungstate, ammonium phosphomolybdate, sodium phosphomolybdate, sodium phosphite, sodium tripolyphosphate and sodium pyrophosphate. Of these phosphate compounds, sodium dihydrogen phosphate, disodium hydrogen phosphate, potassium dihydrogen phosphate and dipotassium hydrogen phosphate are preferred over the others.

Although no particular restriction is placed on the combination of an inorganic fluorine compound and a phosphate compound, it is preferable that the aqueous solution contains sodium fluorozirconate as the inorganic fluorine compound and at least sodium dihydrogen phosphate as the phosphate compound.

The suitable phosphate compound concentration in the aqueous solution is at least 0.01 % by weight, preferably at least 0.1 % by weight, from the viewpoint of improvements in on-machine developability and scumming resistance, and it is at most 20 % by weight, preferably at most 5 % by weight, in terms of solubility.

Although the proportion of each compound in the aqueous solution has no particular limitation, it is preferable that the proportion between an inorganic fluorine compound and a phosphate compound is from 1/200 to 10/1, particularly from 1/30 to 2/1, by weight.

The suitable temperature of the aqueous solution is 20°C or above, preferably 40°C or above, and besides, it is 100°C or below, preferably 80°C or below.

The suitable pH of the aqueous solution is 1 or above, preferably 2 or above, and besides, it is 11 or below, preferably 5 or below.

The sealing with the aqueous solution containing an inorganic fluorine compound has no particular restriction as to the method thereof, but an immersion method and a spray method, for example, can be adopted. Operations in these methods may be performed once or more than once individually, or those methods may be used in combination.

Of those methods, an immersion method is preferable. When treatment is carried out using the immersion method, the suitable treatment time is 1 second or longer, preferably 3 seconds or longer, and besides, it is 100 seconds or shorter, preferably 20 seconds or shorter.

### <Sealing with Steam>

Sealing with steam can be achieved according to a method of bringing pressurized or normal-pressure steam into contact with an anodic oxide coating continuously or discontinuously.

The suitable steam temperature is 80°C or higher, preferably 95°C or higher, and besides, it is 105°C or lower.

The suitable pressure of the steam is in the range of (atmospheric pressure - 50 mmAq) to (atmospheric pressure + 300 mmAq), or 1.008×10⁵ to 1.043×10⁵ Pa.

And the suitable duration of contact with steam is at least 1 second, preferably at least 3 seconds, and besides, it is at most 100 seconds, preferably at most 20 seconds.

### <Sealing with Hot Water>

Sealing with hot water can be achieved according to a method of immersing an anodic oxide coating-formed aluminum sheet in hot water.

The hot water may contain an inorganic salt (e.g., a phosphate) or an organic salt.

The suitable temperature of hot water is 80°C or higher, preferably 95°C or higher, and besides, it is 100°C or lower.

And the suitable duration of immersion in hot water is at least 1 second, preferably at least 3 seconds, and besides, it is at most 100 seconds, preferably at most 20 seconds.

As the water-receptivity imparting treatment usable in the invention, there is the alkali metal silicate method as described in each of U.S. Patent Nos. 2,714,066, 3,181,461, 3,280,734 and 3,902,734. In this method, a substrate undergoes immersion or electrolytic treatment in an aqueous solution of, e.g., sodium silicate. In addition, the method of treating with potassium fluorozirconate disclosed in JP-B-36-22063 and the method of treating with polyvinylphosphonic acid as described in each of U.S. Patent Nos. 3,276,868, 4,153,461 and 4,689,272 can be applied.

It is preferable that the substrate used in the invention has its center-line average roughness in the range of 0.10 to 1.2 µm. In such a roughness range, the substrate can be brought into intimate contact with an image-recording layer and can ensure a sufficient press life and satisfactory scumming resistance.

### <<Inkjet Recording Method and Inkjet Recording Apparatus>>

Inkjet recording methods and inkjet recording apparatus adopted suitably in the invention are described below.

In an inkjet recording method, it is preferable that the ink composition as mentioned above is heated up to 40-80°C to lower its viscosity to 7-30 mPas, and then forced to jet out. By adopting such a method, high jet consistency can be achieved. Since most of radiation-curable ink compositions generally have higher viscosity than water-based ink, a variance of their viscosity due to variations in temperature during printing becomes greater. Such a viscosity variance of the ink composition directly has great influences on the size and jet speed of liquid-drops and causes deterioration in image quality. Therefore, the ink composition temperature during the printing is required to be kept as constant as possible. The regulation range of ink composition temperature is adjusted preferably to a set temperature ± 5°C, far preferably to a set temperature ± 2°C, particularly preferably to a set temperature ± 1°C.

One feature of the inkjet recording apparatus is to have a unit for stabilizing the ink composition temperature, and sections to be kept at a constant temperature include the piping system from an ink tank (or an intermediate tank if it is provided) to the jet front of nozzles and all members installed therein.

The temperature control, though it has no particular restriction as to the method thereof, is preferably carried out by, e.g., placing more than one temperature sensor at each piping site and regulating the temperature by heating responsive to the flow rate of ink composition and ambient temperature. The head unit to be heated is preferably cut off or insulated from the outside heat so that the unit body is unaffected by outside air temperature. For reduction in startup time required for a printer to be heated or control of thermal energy loss, it is appropriate that the head unit be thermally insulated from other sections, and what is more, the thermal capacity of the heating unit as a whole be lessened.

Irradiation conditions of radiation are described below. The basic irradiation method is disclosed in JP-A-60-132766. Specifically, a light source is installed on both sides of a head unit, and the head and the light source are made to scan in accordance with a shuttle system. After impact of ink droplets, irradiation is carried out a fixed time interval later. And the curing is completed with another light source accompanied with no drive. In WO 99/54415, the method of using optical fibers and the method of shining a collimated light source on the surface of a mirror mounted on the side of a head unit and irradiating the recording areas with UV light are disclosed. In the invention, those irradiation methods can be used.

In the invention, it is appropriate that the ink composition is heated to a given temperature and the interval between impact and irradiation is controlled so as to fall within the range of 0.01-0.5 second. And it is preferable by far that the radiation exposure is commenced 0.01 to 0.3 second later, especially 0.01 to 0.15 second later. The control of an interval between impact and irradiation to a very short time makes it possible to prevent the ink having impacted a recording material from spreading before being cured. In addition, such a control also enables the irradiation to be commenced before the ink composition permeates into the radiation-inaccessible depth of a recording material even when the recording material is porous, so the incidence of unreacted monomer residues is curbed to result in reduction of a bad smell. The combined use of the aforementioned inkjet recording method and the present ink composition can produce a great synergistic effect. The great effect can be achieved notably in the case of using the ink composition having its ink viscosity at 25°C in the range of 35-500 MPs. By adopting such a recording method, the consistent dot size of ink having impacted can be ensured on various recording materials differing in surface wettability, and the image quality can be improved. Additionally, superimposing colors in order of increasing lightness is preferred in forming color images. When the ink of low lightness is superimposed, the irradiation light is hard to reach the ink situated beneath; as a result, it tends to occur that the curing sensitivity is impaired, the monomer residues increase in quantity, the bad smell is emitted and the adhesiveness deteriorates. In terms of cure acceleration, the color-by-color irradiation is preferred though it is also possible that all of colors ejected in jets are exposed to light all together.

The inkjet recording apparatus used in the invention has no particular restrictions, and it may be commercially available inkjet recording apparatus. In other words, the recording on a recording material by use of commercially available inkjet apparatus is possible in the invention.

### Examples

The invention will now be illustrated more specifically by reference to the following examples, but these examples should not be construed as limiting the scope of the invention.

### EXAMPLE 1

### <<Preparation of Pigment Dispersion>>

Dispersion 1 of each of yellow, magenta, cyan and black pigments was prepared in the following manner. Specifically, each pigment was dispersed by use of a known dispersing apparatus under dispersing conditions adjusted properly so as to make the average particle size of the pigment fall within the range of 0.2-0.3 µm, and then the dispersion thus obtained was filtered under heating, thereby preparing the intended Dispersion 1.

| (Dispersion 1 of Yellow Pigment) | |
|---|---|
| C.I. Pigment Yellow 12 | 10 parts by weight |
| Polymeric dispersant (Solsperse Series, a product of Zeneca Inc.) | 5 parts by weight |
| Stearyl acrylate (Dispersion 1 of Magenta Pigment) | 85 parts by weight |
| C.I. Pigment Red 57:1 | 15 parts by weight |
| Polymeric dispersant (Solsperse Series, a product of Zeneca Inc.) | 5 parts by weight |
| Stearyl acrylate (Dispersion 1 of Cyan Pigment) | 80 parts by weight |
| C.I. Pigment Blue 15:3 | 20 parts by weight |
| Polymeric dispersant (Solsperse Series, a product of Zeneca Inc.) | 5 parts by weight |
| Stearyl acrylate (Dispersion 1 of Black Pigment) | 75 parts by weight |
| C.I. Pigment Black 7 | 20 parts by weight |
| Polymeric dispersant (Solsperse Series, a product of Zeneca Inc.) | 5 parts by weight |
| Stearyl acrylate | 75 parts by weight |

### <<Preparation of Ink>>

Ink of each color was prepared using each Dispersion 1 prepared in advance and according to the following method.

| (Yellow Ink 1) | |
|---|---|
| Dispersion 1 of yellow pigment | 20 parts by weight |
| Compound A-86 shown in Table-1 | 60 parts by weight |
| Compound D-19 shown in Table-4 | 10 parts by weight |
| Compound F-6 shown in Table-6 | 5 parts by weight |
| Polymerization initiator (IRGACURE 184, produced by Ciba Specialty Chemicals) | 5 parts by weight |

| (Magenta Ink 1) | |
|---|---|
| Dispersion 1 of magenta pigment | 20 parts by weight |
| Compound A-86 shown in Table-1 | 60 parts by weight |
| Compound D-19 shown in Table-4 | 10 parts by weight |
| Compound F-6 shown in Table-6 | 5 parts by weight- |
| Polymerization initiator (IRGACURE 184, produced by Ciba Specialty Chemicals) | 5 parts by weight |

| (Cyan Ink 1) | |
|---|---|
| Dispersion 1 of cyan pigment | 15 parts by weight |
| Compound A-86 shown in Table-1 | 650 parts by weight |
| Compound D-19 shown in Table-4 | 10 parts by weight |
| Compound F-6 shown in Table-6 | 5 parts by weight |
| Polymerization initiator (IRGACURE 184, produced by Ciba Specialty Chemicals) | 5 parts by weight |

| (Black Ink 1) | |
|---|---|
| Dispersion 1 of black pigment | 15 parts by weight |
| Compound A-86 shown in Table-1 | 65 parts by weight |
| Compound D-19 shown in Table-4 | 10 parts by weight |
| Compound F-6 shown in Table-6 | 5 parts by weight |
| Polymerization initiator | 5 parts by weight |

| | |
|---|---|
| (IRGACURE 184, produced by Ciba Specialty Chemicals) | |

The thus prepared Ink 1 of each color was passed through a filter with an absolute filtration accuracy of 2 µm to obtain the intended Ink 1 of each color.

### <<Inkjet Image Recording>>

Recording on a recording material was performed using a commercially available inkjet recording apparatus provided with piezo-type inkjet nozzles. The ink-feeding system therein was made up of source tanks, feed piping, feed ink tanks installed immediately in front of an inkjet head, filters and a piezo-type inkjet head, and the section extending from the feed ink tanks to the inkjet head was warmed and protected by a thermal insulator. The temperature sensors were installed in the feed ink tanks and in the vicinity of nozzles of the inkjet head, respectively, and the temperature in the nozzle area was controlled so as to fall within the range of 70°C ± 2°C. The piezo-type inkjet head was actuated so as to eject multiple-size dots of 8 to 30 pl in 720 x 720 dpi resolution. The exposure system, the main scan speed and the jet frequencies were adjusted so that UV-A light was condensed so as to have illuminance of 100 mW/cm² at the exposed surface and the irradiation therewith commenced after a lapse of 0.1 second from impact of ink droplets against a recording material. In addition, the exposure time was made variable, and exposure light energy was applied. Incidentally, the term "dpi" used in the invention refers to the number of dots per 2.54 cm.

By using the foregoing ink set with four different colors, the black ink, the cyan ink, the magenta ink and the yellow ink were ejected sequentially in jets in order of mention at ambient temperature of 25°C, and the ink of each color was irradiated with UV light individually. In order to apply energy enough to cure the ink of each color completely and avoid detection of tackiness by touch with fingers, every exposure was carried out so that the total exposure energy per color was adjusted to 300 mJ/cm². The recording materials used herein were a grained aluminum substrate, a transparent biaxially-stretched polypropylene film having printing suitability obtained by surface treatment, a soft sheet of vinyl chloride, cast-coated paper and commercially available recycled paper. When images of each color were recorded on each of these materials, high-resolution images free of dot spread were obtained. Even in the other case of recording on wood free paper, each ink composition was cured to a sufficient degree and free from a strike-through phenomenon, and besides, there was almost no emission of a bad smell traceable to unreacted monomers. Further, the ink recorded on the film had sufficient flexibility, was not cracked even by bending, and had no-problem in the adhesion test through the peeling of cellophane tape (R).

### EXAMPLES 2 TO 5

### <<Preparation of Ink>>

Magenta ink of four types 2 to 5 were prepared in the following manners.

| (Magenta Ink 2) | |
|---|---|
| Dispersion 1 of magenta pigment | 20 parts by weight |
| Compound A-3 shown in Table 1 Difunctional aromatic urethane acrylat illustrated below | 40 parts by weight |
| (molecular weight: 1,500) | 10 parts by weight |
| Hexafunctional aliphatic urethane acrylate illustrated below (molecular weight: 1,000) | 5 parts by weight |
| Polymerization initiator (IRGACURE 184, produced by Ciba Specialty Chemicals) | 5 parts by weight |

| (Magenta Ink 3) | |
|---|---|
| Dispersion 1 of magenta pigment | 20 parts by weight |
| Compound A-18 shown in Table-1 | 50 parts by weight |
| Lactone-modified acrylate illustrated below (molecular weight: 458) | 20 parts by weight |
| Hexafunctional aliphatic urethane acrylate illustrated below (molecular weight: 1,000) | 5 parts by weight |
| Polymerization initiator (IRGACURE 184, produced by Ciba Specialty Chemicals) | 5 parts by weight |

| (Magenta Ink 4) | |
|---|---|
| Dispersion 2 of magenta pigment | 20 parts by weight |
| Compound A-29 shown in Table-1 | 70 parts by weight |
| Hexafunctional aliphatic urethane acrylate illustrated below (molecular weight: 1,000) | 5 parts by weight |
| Polymerization initiator (IRGACURE 184, produced by Ciba Specialty Chemicals) | 5 parts by weight |

### <Preparation of Dispersion 2 of Magenta Pigment>

The Dispersion 2 of magenta pigment was prepared in the same manner as the Dispersion 1 of magenta pigment in Example 1, except that isobornyl acrylate was used in place of stearyl acrylate.

| (Magenta Ink 5) | |
|---|---|
| Dispersion 2 of magenta pigment | 20 parts by weight |
| Compound A-47 shown in Table-1 | 60 parts by weight |
| Tetramethylolmethane triacrylate | 15 parts by weight |
| Polymerization initiator (IRGACURE 184, produced by Ciba Specialty Chemicals) | 5 parts by weight |

### COMPARATIVE EXAMPLES 1 AND 2

### <<Preparation of Ink>>

Magenta Ink 6 and magenta Ink 7 were prepared in the following manners.

| (Magenta Ink 6: Comparative Example 1) | |
|---|---|
| Dispersion 3 of magenta pigment | 20 parts by weight |
| Triethylene glycol diacrylate | 45 parts by weight |
| 1,4-Butanediol diacrylate | 30 parts by weight |
| Polymerization initiator (IRGACURE, produced by Ciba Specialty Chemicals) | 5 parts by weight |

### <Preparation of Dispersion 3 of Magenta Pigment>

The Dispersion 3 of magenta pigment was prepared in the same manner as the Dispersion 1 of magenta pigment in Example 1, except that triethylene glycol diacrylate was used in place of stearyl acrylate.

| (Magenta Ink 7: Comparative Example 2) | |
|---|---|
| Dispersion 1 of magenta pigment | 20 parts by weight |
| Stearyl acrylate | 60 parts by weight |
| Difunctional aromatic urethane acrylate illustrated below (molecular weight: 1,500) | 10 parts by weight |
| Hexafunctional aliphatic urethane acrylate illustrated below (molecular weight: 1,000) | 5 parts by weight |
| Polymerization initiator (IRGACURE 184, produced by Ciba Specialty Chemicals) | 5 parts by weight |

### Difunctional aromatic urethane acrylate:

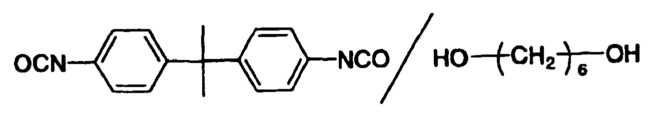

condensate (Mw: 1,500) the end of which is capped with:

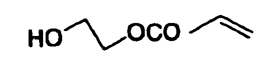

### Hexafunctional aliphatic urethane acrylate:

OCN-(CH₂)₆-NCO/HO-(CH₂)₄-OH

condensate (Mw:1,500) the end of which is capped with:

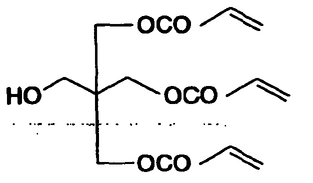

### Lactone-modified acrylate

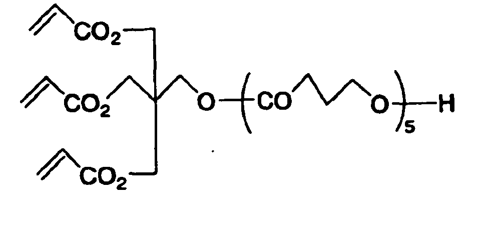

The ink compositions prepared in Examples and Comparative Examples was found to have their ink viscosity within the range of 7 to 20 mPa·s at the injection temperature.

### <<Inkjet Image Recording>>

Magenta images were printed using the thus prepared Magenta Ink 2 to 7 and Magenta Ink 1 prepared in Example 1, respectively, in accordance with the method as described in Example 1.

### <<Evaluations of Inkjet Images>>

The images printed with each of the magenta ink compositions were examined for sensitivity required for curing, permeability into commercially available recycled paper, ink spread on a grained aluminum substrate, adhesion to a grained aluminum substrate, press life and storage stability in accordance with the following methods, respectively.

### (Measurement of Sensitivity to Curing)

The sensitivity to curing was defined as the amount of light exposure energy (mJ/cm²) required for disappearance of a tacky feel from each image surface by UV irradiation. The smaller energy value indicates that the ink used has the higher sensitivity to curing.

### (Evaluation of Permeability into Commercially Available Recycled Paper)

The magenta images printed on commercially available recycled paper were examined on their ink permeability, and evaluation thereof was made in accordance with the following criteria.
Excellent: Permeation is negligible and there is no smell of remaining monomers. Passable : Slight permeation of ink and a faint smell of remaining monomers are perceived.
Failure : Ink completely permeates through paper and a strong smell of remaining monomers is perceived.

### (Evaluation of Ink Spread on Grained Aluminum Substrate)

The magenta images printed on a grained aluminum substrate were examined on their ink spread, and evaluation thereof was made in accordance with the following criteria.
Excellent: No spread of ink is observed between adjacent dots.
Passable : Slight dot spread is observed.
Failure : Dots are spread and images are obviously blurred.

### (Evaluation of Adhesion to Grained Aluminum Substrate)

For adhesion test of the images printed on a grained aluminum substrate in the foregoing manner, two samples per printed surface were prepared. As to one sample, no cuts were made on the printed surface; while the other was prepared by cutting 11 vertical lines and 11 horizontal lines at 1-mm intervals on the printed surface to make 10x10 1-mm square cuts in a grid pattern in accordance with JISK 5400. A cellophane tape was affixed to each printed surface, and then peeled quickly at a 90° angle. After this action, the appearance of the printed image or the grid pattern remaining unpeeled was evaluated according to the following criteria.
Excellent: No exfoliation of printed image is observed at all even in the grid-pattern test.
Passable : A little flakes of ink are observed in the grid-pattern test, but almost no exfoliation is observed so far as the ink-printed surface gets no scratch.
Failure : The printed image is easily peeled away with acellophane tape (R) under both test conditions.

### (Evaluation of Press Life)

Printing was performed with a Heidel KOR-D machine in which a grained aluminum substrate having thereon images printed with each magenta ink composition in the foregoing manner was mounted as a printing plate. The number of the copies printed until the printing plate came to off was adopted as a measure of press life. And the press lives are shown as relative values (with Example 1 being taken as 100). The greater number means that the ink composition is the longer in press life and the more suitable for platemaking.

### (Evaluation of Storage Stability)

After each ink composition was stored for 3 days under the condition of 75%RH-60°C, the ink viscosity at the ejection temperature was measured. The increment of ink viscosity was expressed in terms of the ratio of ink viscosity after storage to ink viscosity before storage. The case in which the ratio is nearer to 1.0 because of almost no change in viscosity offers the better storage stability. When the ratio goes up to over 1.5, undesirable clogging often occurs at the time of ejection.

The evaluation results thus obtained are shown in Table A.

**Table A**

| | Magenta Ink Number | Sensitivity to Curing (mJ/cm²) | Permeability | Ink Spread | Adhesion | Press Life | Storage Stability |
|---|---|---|---|---|---|---|---|
| Example 1 | 1 | 140 | excellent | excellent | excellent | 100 | 1.1 |
| Example 2 | 2 | 130 | excellent | excellent | excellent | 120 | 1.2 |
| Example 3 | 3 | 150 | excellent | excellent | excellent | 110 | 1.1 |
| Example 4 | 4 | 120 | excellent | excellent | excellent | 120 | 1.2 |
| Example 5 | 5 | 150 | excellent | excellent | excellent | 100 | 1.1 |
| Comparative Example 1 | 6 | 200 | passable | passable | passable | 50 | 1.6 |
| Comparative Example 2 | 7 | 200 | failure | failure | failure | 80 | 1.5 |

As can be seen from Table A, the ink compositions using the present α-heteromethacrylic compounds have high sensitivity to radiation exposure, can form images of high quality on paper and have satisfactory storage stability, and can ensure long press life and high-quality image formation when they are used for producing printing plate.

The entire disclosure of each and every foreign patent application from which the benefit of foreign priority has been claimed in the present application is incorporated herein by reference, as if fully set forth herein.

While the invention has been described in detail and with reference to specific embodiments thereof, it will be apparent to one skilled in the art that various changes and modifications can be made therein without departing from the spirit and scope thereof.

## Claims

1. An ink composition for inkjet recording, capable of being cured upon radiation exposure, which comprises: a coloring material; and a polymerizing compound having a structure represented by formula (I): 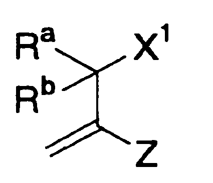 wherein R^{a} and R^{b} each independently represent a hydrogen atom, a halogen atom, a cyano group or an organic group; Z represents CN or COX²; X¹ represents a halogen atom or a group bonded to α-carbon via a hetero atom; X² represents a halogen atom or a group bonded to the carbonyl group via a hetero atom; and X¹ and X², R^{a} and R^{b}, X¹ and R^{a}, or X¹ and R^{b} may combine with each other to form a ring structure, wherein the ink composition has an ink viscosity of 7 to 20 mPa · s at the ejection-time temperature.

2. The ink composition for inkjet recording according to claim 1, wherein the organic group is at least one of a hydrocarbon group, a substituted oxy group, a substituted thio group, a substituted amino group, a substituted carbonyl group and a carboxylato group.

3. The ink composition for inkjet recording according to claim 1, wherein the group bonded to α-carbon via the hetero atom is at least one of a hydroxyl group, a substituted oxy group, a mercapto group, a substituted thio group, an amino group, a substituted amino group, a sulfo group, a sulfonato group, a substituted sulfinyl group, a substituted sulfonyl group, a phosphono group, a substituted phosophono group, a phosphonato group, a substituted phosphonato group, a nitro group and a heterocyclic group.

4. The ink composition for inkjet recording according to claim 1, wherein the group bonded to the carbonyl group via the hetero atom is at least one of a hydroxyl group, a substituted oxy group, a mercapto group, a substituted thio group, an amino group, a substituted amino group and a heterocyclic group.

5. The ink composition for inkjet recording according to claim 1, which has the polymerizing compound in an amount of 5 to 95 % by weight.

6. The ink composition for inkjet recording according to claim 1, which comprises another polymerizing compound other than the polymerizing compound having the structure represented by formula (I).

7. The ink composition for inkjet recording according to claim 6, wherein the polymerizing compound other than the polymerizing compound having the structure represented by formula (I) is at least one of a monoacrylate compound, multifunctional acrylate monomer and a multifunctional acrylate oligomer.

8. The ink composition for inkjet recording according to claim 6, which has the polymerizing compound other than the polymerizing compound having the structure represented by formula (I) in an amount of 5 to 85 % by weight of all of polymerizing compounds.

9. The ink composition for inkjet recording according to claim 1, which comprises a polymerization initiator.

## Patentansprüche

1. Tintenzusammensetzung zum Tintenstrahlaufzeichnen, die durch Bestrahlung gehärtet werden kann, umfassend ein Färbematerial und eine polymerisierende Verbindung mit einer Struktur mit der Formel (I): 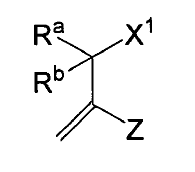 worin R^{a} und R^{b} jeweils unabhängig ein Wasserstoffatom, Halogenatom, eine Cyano-Gruppe oder eine organische Gruppe bedeuten; Z CN oder COX² ist; X¹ ein Halogenatom oder eine Gruppe ist, die an ein α-Kohlenstoff über ein Heteroatom gebunden ist; X² ein Halogenatom oder eine Gruppe ist, die an die Carbonyl-Gruppe über ein Heteroatom gebunden ist; und X¹ und X², R^{a} und R^{b}, X¹ und R^{a} oder X¹ und R^{b} miteinander zur Bildung einer Ringstruktur kombinieren können, worin die Tintenzusammensetzung eine Tintenviskosität von 7 bis 20 mPa·s bei der Temperatur zum Zeitpunkt der Ejektion aufweist.

2. Tintenzusammensetzung zum Tintenstrahlaufzeichnen nach Anspruch 1, worin die organische Gruppe zumindest eine von einer Kohlenwasserstoff-Gruppe, substituierten Oxy-Gruppe, substituierten Thio-Gruppe, substituierten Amino-Gruppe, substituierten Carbonyl-Gruppe und Carboxylato-Gruppe ist.

3. Tintenzusammensetzung zum Tintenstrahlaufzeichnen nach Anspruch 1, worin die Gruppe, die über das Heteroatom an einen α-Kohlenstoff gebunden ist, zumindest eine von einer Hydroxyl-Gruppe, substituierten Oxy-Gruppe, Mercapto-Gruppe, substituierten Thio-Gruppe, Amino-Gruppe, substituierten Amino-Gruppe, Sulfo-Gruppe, Sulfonato-Gruppe, substituierten Sulfinyl-Gruppe, substituierten Sulfonyl-Gruppe, Phosphono-Gruppe, substituierten Phosphono-Gruppe, Phosphonato-Gruppe, substituierten Phosphonato-Gruppe, Nitro-Gruppe und heterocyclischen Gruppe ist.

4. Tintenzusammensetzung zum Tintenstrahlaufzeichnen nach Anspruch 1, worin die Gruppe, die über das Heteroatom an die Carbonyl-Gruppe gebunden ist, zumindest eine von einer Hydroxyl-Gruppe, substituierten Oxy-Gruppe, Mercapto-Gruppe, substituierten Thio-Gruppe, Amino-Gruppe, substituierten Amino-Gruppe und heterocyclischen Gruppe ist.

5. Tintenzusammensetzung zum Tintenstrahlaufzeichnen nach Anspruch 1, die die polymerisierende Verbindung in einer Menge von 5 bis 95 Gew.-% enthält.

6. Tintenzusammensetzung zum Tintenstrahlaufzeichnen nach Anspruch 1, die eine andere polymerisierende Verbindung als die polymerisierende Verbindung mit der Struktur mit der Formel (I) umfasst.

7. Tintenzusammensetzung zum Tintenstrahlaufzeichnen nach Anspruch 6, worin die andere polymerisierende Verbindung als die polymerisierende Verbindung mit der Struktur mit der Formel (I) zumindest eine von einer Monoacrylat-Verbindung, multifunktionellem Acrylatmonomer und multifunktionellem Acrylatoligomer ist.

8. Tintenzusammensetzung zum Tintenstrahlaufzeichnen nach Anspruch 6, die die andere polymerisierende Verbindung als die polymerisierende Verbindung mit der Struktur mit der Formel (I) in einer Menge von 5 bis 85 Gew.-% von allen polymerisierenden Verbindungen aufweist.

9. Tintenzusammensetzung zum Tintenstrahlaufzeichnen nach Anspruch 1, die einen Polymerisationsinitiator umfasst.

## Revendications

1. Composition d'encre pour un enregistrement à jet d'encre, capable d'être durcie lors d'une exposition à une radiation, qui comprend: un matériau colorant ; et un composé se polymérisant ayant une structure représentée par la formule (I) : 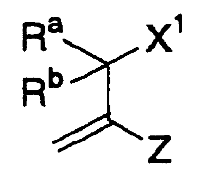 dans laquelle R^{a} et R^{b} représentent chacun indépendamment un atome d'hydrogène, un atome d'halogène, un groupement cyano ou un groupement organique ; Z représente CN ou COX² ; X¹ représente un atome d'halogène ou un groupement fixé au carbone en α via un hétéroatome ; X² représente un atome d'halogène ou un groupement fixé au groupement carbonyle via un hétéroatome ; et X¹ et X², R^{a} et R^{b}, X¹ et R^{a} ou X¹ et R^{b} peuvent se combiner les uns avec les autres pour former une structure cyclique, dans laquelle la composition d'encre a une viscosité d'encre de 7 à 20 mPa · s à la température du moment de l'éjection.

2. Composition d'encre pour un enregistrement à jet d'encre selon la revendication 1, dans laquelle le groupement organique est au moins un parmis un groupement d'hydrocarbure, un groupement oxy substitué, un groupement thio substitué, un groupement amino substitué, un groupement carbonyle substitué et un groupement carboxylato.

3. Composition d'encre pour un enregistrement à jet d'encre selon la revendication 1, dans laquelle le groupement fixé au carbone en α via l'hétéroatome est au moins un parmis un groupement hydroxyle, un groupement oxy substitué, un groupement mercapto, un groupement thio substitué, un groupement amino, un groupement amino substitué, un groupement sulfo, un groupement sulfonato, un groupement sulfinyle substitué, un groupement sulfonyle substitué, un groupement phosphono, un groupement phosphono substitué, un groupement phosphonato, un groupement phosphonato substitué, un groupement nitro et un groupement hétérocyclique.

4. Composition d'encre pour un enregistrement à jet d'encre selon la revendication 1, dans laquelle le groupement fixé au groupement carbonyle via l'hétéroatome est au moins un parmis un groupement hydroxyle, un groupement oxy substitué, un groupement mercapto, un groupement thio substitué, un groupement amino, un groupement amino substitué et un groupement hétérocyclique.

5. Composition d'encre pour un enregistrement à jet d'encre selon la revendication 1, qui a le composé se polymérisant dans une quantité de 5 à 95 % en poids.

6. Composition d'encre pour un enregistrement à jet d'encre selon la revendication 1, qui comprend un autre composé se polymérisant autre que le composé se polymérisant ayant la structure représentée par la formule (I).

7. Composition d'encre pour un enregistrement à jet d'encre selon la revendication 6, dans laquelle le composé se polymérisant autre que le composé se polymérisant ayant la structure représentée par la formule (I) est au moins un parmis un composé de monoacrylate, un monomère d'acrylate multifonctionnel et un oligomère d'acrylate multifonctionnel.

8. Composition d'encre pour un enregistrement à jet d'encre selon la revendication 6, qui a le composé se polymérisant autre que le composé se polymérisant ayant la structure représentée par la formule (I), dans une quantité de 5 à 85 % en poids de tous les composés se polymérisant.

9. Composition d'encre pour un enregistrement à jet d'encre selon la revendication 1, qui comprend un initiateur de polymérisation.
